# EUROPEAN PATENT APPLICATION

(11) **EP 4 842 173 A1**
(43) Date of publication of application: **18.11.2026**
(21) Application number: 24940226.4
(22) Date of filing: 10.05.2024
(51) Int. Cl.: H10K 50/13

(54) **DISPLAY PANEL AND DISPLAY DEVICE**

(71) Applicant: BOE TECHNOLOGY GROUP CO., LTD., Beijing 100015 (CN)
(72) Inventor: WEN, Guanyin, Beijing 100176 (CN); LI, Yansong, Beijing 100176 (CN); MA, Lihui, Beijing 100176 (CN)
(74) Representative: Hoffmann Eitle
(86) International application number: PCT/CN2024/092408
(87) International publication number: WO 2025/231863

(57) **Abstract**

A display panel and a display device. The display panel comprises, successively stacked, a first electrode, a first light-emitting layer and a second electrode. The first electrode is configured to inject holes into the first light-emitting layer. The second electrode is configured to inject electrons into the first light-emitting layer. The first light-emitting layer comprises at least two stacked light-emitting sub-layers, the hole mobility of each of the light-emitting sub-layers being less than the electron mobility of the light-emitting sub-layer. The display panel is used for displaying an image.

## Description

### TECHNICAL FIELD

The present disclosure relates to the field of display technologies, and in particular, to a display panel and a display apparatus.

### BACKGROUND

With the continuous development of display technologies, display apparatuses have gradually come throughout people's lives. Organic light-emitting diode (OLED) display panels are widely used in display apparatuses such as mobile phones, televisions, and notebook computers due to their advantages of self-illumination, low power consumption, wide viewing angle, fast response, and high contrast.

### SUMMARY

In an aspect, a display panel is provided, including a first electrode, a first light-emitting layer, and a second electrode that are stacked in sequence. The first electrode is configured to inject holes into the first light-emitting layer, and the second electrode is configured to inject electrons into the first light-emitting layer. The first light-emitting layer includes at least two light-emitting sub-layers that are stacked. Hole mobility of each light-emitting sub-layer is less than electron mobility of the light-emitting sub-layer.

In some embodiments, a ratio of the electron mobility to the hole mobility of each light-emitting sub-layer is greater than or equal to 10.

In some embodiments, the first light-emitting layer includes a first light-emitting sub-layer and a second light-emitting sub-layer adjacent to the first light-emitting sub-layer; the first light-emitting sub-layer is closer to the first electrode than the second light-emitting sub-layer; and a thickness of the first light-emitting sub-layer is less than a thickness of the second light-emitting sub-layer.

In some embodiments, the thickness of the first light-emitting sub-layer is in a range of 5 nm to 10 nm.

In some embodiments, the first light-emitting layer includes a first light-emitting sub-layer and a second light-emitting sub-layer adjacent to the first light-emitting sub-layer; the first light-emitting sub-layer is closer to the first electrode than the second light-emitting sub-layer; and electron mobility of the second light-emitting sub-layer is greater than electron mobility of the first light-emitting sub-layer.

In some embodiments, the first light-emitting layer includes at least three light-emitting sub-layers; and in a direction from the first electrode to the second electrode, electron mobility of the at least three light-emitting sub-layers increases sequentially.

**In** some embodiments, the first light-emitting layer includes a first light-emitting sub-layer and a second light-emitting sub-layer adjacent to the first light-emitting sub-layer; the first light-emitting sub-layer is closer to the first electrode than the second light-emitting sub-layer; and hole mobility of the second light-emitting sub-layer is greater than or equal to hole mobility of the first light-emitting sub-layer.

**In** some embodiments, the first light-emitting layer includes at least three light-emitting sub-layers; and in a direction from the first electrode to the second electrode, hole mobility of the at least three light-emitting sub-layers increases sequentially.

**In** some embodiments, an absolute value of a highest occupied molecular orbital energy level of the first light-emitting sub-layer of the first light-emitting layer is less than or equal to an absolute value of a highest occupied molecular orbital energy level of the second light-emitting sub-layer of the first light-emitting layer; and an absolute value of a lowest unoccupied molecular orbital energy level of the first light-emitting sub-layer of the first light-emitting layer is less than or equal to an absolute value of a lowest unoccupied molecular orbital energy level of the second light-emitting sub-layer of the first light-emitting layer.

In some embodiments, the display panel further includes a hole transport layer and an electron blocking layer that are stacked in sequence in a direction away from the first electrode, and the hole transport layer and the electron blocking layer are located between the first light-emitting sub-layer and the first electrode. An absolute value of a highest occupied molecular orbital energy level of the hole transport layer is less than or equal to an absolute value of a highest occupied molecular orbital energy level of the electron blocking layer.

In some embodiments, the absolute value of the highest occupied molecular orbital energy level of the electron blocking layer is greater than or equal to an absolute value of a highest occupied molecular orbital energy level of the first light-emitting sub-layer.

In some embodiments, the display panel further includes a hole blocking layer located between the second light-emitting sub-layer and the second electrode. An absolute value of a lowest unoccupied molecular orbital energy level of the hole blocking layer is greater than or equal to an absolute value of a lowest unoccupied molecular orbital energy level of the second light-emitting sub-layer.

In some embodiments, a difference between the absolute value of the lowest unoccupied molecular orbital energy level of the hole blocking layer and the absolute value of the lowest unoccupied molecular orbital energy level of the second light-emitting sub-layer is less than or equal to 0.2 eV.

In some embodiments, the display panel further includes an electron transport layer located between the hole blocking layer and the second electrode. An absolute value of a lowest unoccupied molecular orbital energy level of the electron transport layer is greater than or equal to an absolute value of a lowest unoccupied molecular orbital energy level of the hole blocking layer.

In some embodiments, a difference between the absolute value of the lowest unoccupied molecular orbital energy level of the electron transport layer and the absolute value of the lowest unoccupied molecular orbital energy level of the hole blocking layer is less than or equal to 0.2 eV.

In some embodiments, the display panel includes a red light-emitting layer, a green light-emitting layer, and a blue light-emitting layer, and at least one of the red light-emitting layer, the green light-emitting layer, and the blue light-emitting layer is the first light-emitting layer.

In some embodiments, each of the red light-emitting layer, the green light-emitting layer, and the blue light-emitting layer is the first light-emitting layer.

In some embodiments, the display panel includes at least two first light-emitting layers that are stacked and at least one charge generation layer; and a charge generation layer is disposed between any two adjacent first light-emitting layers.

In some embodiments, the display panel further includes a second light-emitting layer and a charge generation layer. The charge generation layer is located between the first light-emitting layer and the second light-emitting layer. The second light-emitting layer is of a single-layer structure. The second light-emitting layer is closer to the first electrode than the first light-emitting layer, or the second light-emitting layer is farther away from the first electrode than the first light-emitting layer.

In another aspect, a display apparatus is provided, including the display panel as described in any one of the above embodiments and a cover plate. The cover plate is disposed on a light exit side of the display panel.

### BRIEF DESCRIPTION OF THE DRAWINGS

In order to describe technical solutions in the present disclosure more clearly, the accompanying drawings to be used in some embodiments of the present disclosure will be introduced briefly. However, the accompanying drawings to be described below are merely drawings of some embodiments of the present disclosure, and a person of ordinary skill in the art can obtain other drawings according to these accompanying drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram of a display apparatus, in accordance with some embodiments;
FIG. 2 is a sectional view of the display apparatus in FIG. 1 taken along the line B-B;
FIG. 3 is a structural diagram of a display panel, in accordance with some embodiments;
FIG. 4A is a diagram showing a film layer structure of a sub-pixel in a display panel, in accordance with some embodiments;
FIG. 4B is a diagram showing a film layer structure of a sub-pixel in a display panel, in accordance with some other embodiments;
FIG. 5 is a diagram showing a film layer structure of a sub-pixel in a display panel, in accordance with yet some other embodiments;
FIG. 6 is a diagram showing a film layer structure of a sub-pixel in a display panel, in accordance with yet some other embodiments;
FIG. 7A is a graph showing a corresponding relationship between voltage and current density of a first color sub-pixel (i.e. a red sub-pixel) in a display panel;
FIG. 7B is a graph showing a corresponding relationship between voltage and current density of a second color sub-pixel (i.e. a green sub-pixel) in a display panel;
FIG. 7C is a graph showing a corresponding relationship between voltage and current density of a third color sub-pixel (i.e. a blue sub-pixel) in a display panel;
FIG. 8A is a graph showing a corresponding relationship between luminance and efficiency of a first color sub-pixel (i.e. a red sub-pixel) in a display panel;
FIG. 8B is a graph showing a corresponding relationship between luminance and efficiency of a second color sub-pixel (i.e. a green sub-pixel) in a display panel;
FIG. 8C is a graph showing a corresponding relationship between luminance and efficiency of a third color sub-pixel (i.e. a blue sub-pixel) in a display panel;
FIG. 9 is a diagram showing a film layer structure of a sub-pixel in a display panel, in accordance with yet some other embodiments;
FIG. 10A is a graph showing a corresponding relationship between usage time and luminance of a first color sub-pixel (i.e. a red sub-pixel) in a display panel;
FIG. 10B is a graph showing a corresponding relationship between usage time and luminance of a second color sub-pixel (i.e. a green sub-pixel) in a display panel;
FIG. 10C is a graph showing a corresponding relationship between usage time and luminance of a third color sub-pixel (i.e. a blue sub-pixel) in a display panel;
FIG. 11 is a diagram showing a film layer structure of a sub-pixel in a display panel, in accordance with yet some other embodiments;
FIG. 12 is a schematic diagram of lowest unoccupied molecular orbital energy levels and highest occupied molecular orbital energy levels of film layers of a sub-pixel in a display panel, in accordance with yet some other embodiments;
FIG. 13A is a diagram showing a film layer structure of a sub-pixel in a display panel, in accordance with yet some other embodiments;
FIG. 13B is a diagram showing a film layer structure of a sub-pixel in a display panel, in accordance with yet some other embodiments;
FIG. 13C is a diagram showing a film layer structure of a sub-pixel in a display panel, in accordance with yet some other embodiments;
FIG. 14A is a diagram showing a film layer structure of a sub-pixel in a display panel, in accordance with yet some other embodiments;
FIG. 14B is a diagram showing a film layer structure of a sub-pixel in a display panel, in accordance with yet some other embodiments;
FIG. 14C is a diagram showing a film layer structure of a sub-pixel in a display panel, in accordance with yet some other embodiments;
FIG. 15 is a diagram showing a film layer structure of a sub-pixel in a display panel, in accordance with yet some other embodiments;
FIG. 16A is a diagram showing a film layer structure of a sub-pixel in a display panel, in accordance with yet some other embodiments;
FIG. 16B is a diagram showing a film layer structure of a sub-pixel in a display panel, in accordance with yet some other embodiments; and
FIG. 17 is a diagram showing a film layer structure of a sub-pixel in a display panel, in accordance with yet some other embodiments.

### DETAILED DESCRIPTION

The technical solutions in some embodiments of the present disclosure will be described clearly and completely with reference to the accompanying drawings. However, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment," "some embodiments," "exemplary embodiments," "example," "specific example," or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

The terms "first" and "second" are used for descriptive purposes only, and are not to be construed as indicating or implying a relative importance or implicitly indicating the number of indicated technical features. Thus, features defined with "first" or "second" may explicitly or implicitly include one or more of the features. In the description of the embodiments of the present disclosure, the term "multiple", "a plurality of" or "the plurality of" means two or more unless otherwise specified.

In the description of some embodiments, the expressions "coupled," "connected," and derivatives thereof may be used. The term "connected" should be understood in a broad sense. For example, the term "connected" may represent a fixed connection, a detachable connection, or a one-piece connection, or may represent a direct connection, or may represent an indirect connection through an intermediate medium. The term "coupled" indicates that two or more components are in direct physical or electrical contact with each other. The term "coupled" or "communicatively coupled" may also indicate that two or more components are not in direct contact with each other, but still cooperate or interact with each other. The embodiments disclosed herein are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes following three combinations: only A, only B, and a combination of A and B.

As used herein, the term "if" is optionally construed as "when" or "in a case where" or "in response to determining" or "in response to detecting", depending on the context. Similarly, depending on the context, the phrase "if it is determined that" or "if [a stated condition or event] is detected" is optionally construed as "in a case where it is determined that", "in response to determining that", "in a case where [the stated condition or event] is detected" or "in response to detecting [the stated condition or event]".

The phrase "applicable to" or "configured to" used herein has an open and inclusive meaning, which does not exclude devices that are applicable to or configured to perform additional tasks or steps.

In addition, the phrase "based on" used is meant to be open and inclusive, since a process, step, calculation or other action that is "based on" one or more of the stated conditions or values may, in practice, be based on additional conditions or value exceeding those stated.

The term such as "about," "substantially," or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel," "perpendicular," or "equal" as used herein includes a stated condition and a condition similar to the stated condition. A range of the similar condition is within an acceptable deviation range, and the acceptable deviation range is determined by a person of ordinary skill in the art, considering measurement in question and errors associated with measurement of a particular quantity (i.e., the limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be that, for example, a difference between the two that are equal is less than or equal to 5% of either of the two.

It will be understood that, when a layer or element is referred to as being on another layer or substrate, it may be that the layer or element is directly on the another layer or substrate, or it may be that intermediate layer(s) exist between the layer or element and the another layer or substrate.

Exemplary embodiments are described herein with reference to sectional views and/or plan views that are schematic illustrations of idealized embodiments. In the drawings, thicknesses of layers and areas of regions are enlarged for clarity. Variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature of being curved. Thus, the regions shown in the accompanying drawings are schematic in nature, and their shapes are not intended to show actual shapes of the regions in a device, and are not intended to limit the scope of the exemplary embodiments.

For the convenience of the following description, an XYZ coordinate system is established. A third direction Z is a thickness direction of a display apparatus, an XY plane is perpendicular to the Z direction, and a first direction X and a second direction Y intersect. For example, the first direction X and the second direction Y are perpendicular to each other.

It will be noted that, for example, F1/F shown in the accompanying drawings of the present disclosure indicates that a component is both F1 and F, and other similar symbols shown in the accompanying drawings also follow the above explanation.

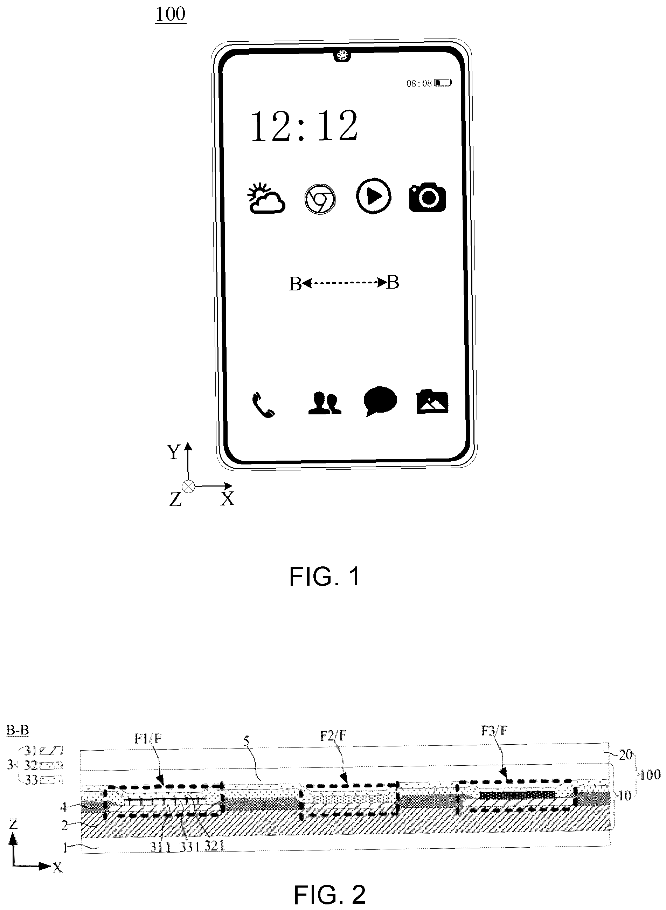

As shown in FIG. 1, some embodiments of the present disclosure provide a display apparatus 100.

For example, the display apparatus 100 may be any apparatus that displays images whether in motion (e.g., videos) or stationary (e.g., static images), and whether literal or graphical. More specifically, it is expected that the embodiments may be implemented in or associated with a plurality of electronic devices. The plurality of electronic devices may include (but are not limit to), for example, mobile telephones, wireless devices, personal data assistants (PDAs), hand-held or portable computers, GPS receivers/navigators, cameras, MP4 video players, video cameras, game consoles, watches, clocks, calculators, TV monitors, flat panel displays, computer monitors, car displays (such as odometer displays, etc.), navigators, cockpit controllers and/or displays, camera view displays (such as rear view camera displays in vehicles), electronic photos, electronic billboards or indicators, projectors, building structures, packagings and aesthetic structures (such as a display for an image of a piece of jewelry), etc. FIG. 1 is illustrated by taking an example in which the display apparatus 100 is a mobile phone.

The display apparatus 100 may be an electroluminescent display apparatus or a photoluminescence display apparatus. In the case where the display apparatus 100 is an electroluminescent display apparatus, the electroluminescent display apparatus may be an organic light-emitting diode (OLED) display apparatus or a quantum dot light-emitting diode (QLED) display apparatus. In the case where the display apparatus 100 is a photoluminescent display apparatus, the photoluminescent display apparatus may be a quantum dot photoluminescent display apparatus.

Some embodiments of the present disclosure will be schematically described below by taking an example in which the display apparatus 100 is an OLED display apparatus. However, the implementations of the present disclosure include but are not limited to this, and any other display apparatus may also be considered as long as the same technical concept is applied.

In some embodiments, as shown in FIG. 2, FIG. 2 is a sectional view of the display apparatus 100 in FIG. 1 taken along the line B-B. The display apparatus 100 includes a display panel 10 and a cover plate 20. The cover plate 20 is disposed on a light exit side of the display panel 10.

The cover plate 20 may separate the display panel 10 from an external environment and protect the display panel 10.

For example, the cover plate 20 may be a single-layer cover plate, or may be a cover plate 20 in which multiple layers are laminated together through an adhesive material.

For example, the cover plate 20 may be a silicate glass cover plate, such as curved glass or ultra-thin glass.

The cover plate 20 may also be a flexible polymer film cover plate, such as transparent polyimide, polyethylene terephthalate (PET) or polyurethane.

The cover plate 20 may also be a combination of the above-mentioned flexible polymer films, or a combination of a flexible polymer film and silicate glass.

In some embodiments, the display apparatus 100 may further include a circuit board (not shown in figures). The circuit board is electrically connected to the display panel 10, and is configured to drive the display panel 10 to display images.

For example, the circuit board includes but is not limited to a printed circuit board (PCB) and a flexible printed circuit board (FPC).

In some embodiments, the display apparatus 100 may further include an under-screen camera, an under-screen fingerprint recognition sensor, etc., so that the display apparatus 100 can implement various functions such as photographing, video recording, fingerprint recognition, or face recognition, which will not be limited in the present disclosure and can be adaptively designed according to actual needs.

The display panel 10 will be described in detail below.

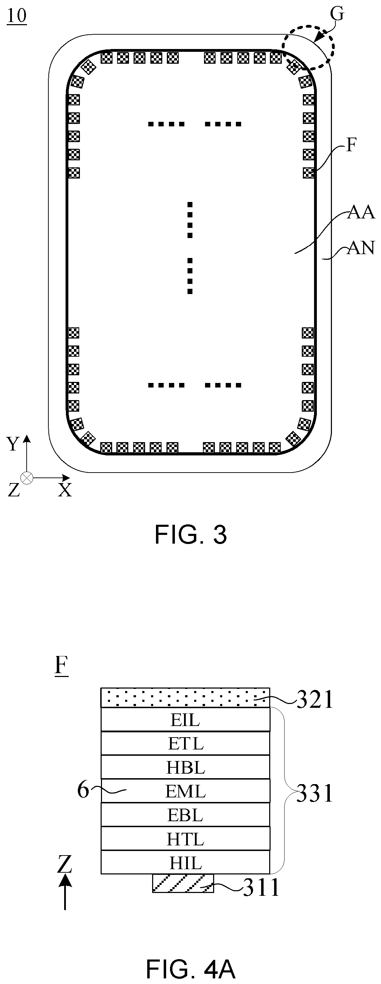

In some embodiments, as shown in FIG. 3, FIG. 3 is a structural diagram of a display panel 10 according to some embodiments. The display panel 10 may be of a rectangular structure.

It will be noted that, the term "rectangular structure" means that a border of the display panel 10 is in a shape of a rectangle as a whole, but is not limited to a standard rectangle. That is, "rectangle" herein includes not only a standard rectangle but also a shape similar to the rectangle in consideration of process conditions. For example, as shown in FIG. 3, long and short sides of the rectangle are curved at each intersecting position (i.e. corners G), that is, the corners G are smooth, so that the border of the display panel 10 is in a shape of a rounded rectangle in a plan view.

In some other embodiments, the display panel 10 may be of a circular structure, or other shapes with corners.

Some embodiments of the present disclosure will be schematically described below by taking an example the display panel 10 is of a rectangular structure. However, the implementations of the present disclosure include but are not limited to this, and the shape display panel 10 may also be any other shape.

In some embodiments, with continued reference to FIG. 3, the display panel 10 has a display region AA for displaying images and a peripheral region AN located on at least one side of the display region AA.

For example, the peripheral region AN is located on one side of the display region AA.

For another example, the peripheral region AN is located on two opposite sides of the display region AA.

For yet another example, as shown in FIG. 3, the peripheral region AN surrounds the display region AA.

It will be noted that the specific arrangement of the peripheral region AN is related to the specific design of the display panel 10, which can be designed according to actual needs. This is only used as an exemplary description and is not intended to limit the present disclosure.

In some embodiments, with continued reference to FIGS. 2 and 3, the display region AA of the display panel 10 is provided therein with a plurality of sub-pixels F, and the sub-pixels F are the smallest light-emitting units in the display region AA.

For example, the plurality of sub-pixels F in the display region AA of the display panel 10 may emit light of the same color, and the display panel 10 may further include a color filter layer disposed on a light exit side of the plurality of sub-pixels F. For example, the plurality of sub-pixels F all emit color light, such as white light, red light, green light or blue light. In this case, after passing through the color filter layer, the color light emitted by the sub-pixel F remains the same color light, or is converted into other color light and exits. Therefore, when the plurality of sub-pixels F emit light of the same color, the display panel 10 may achieve multi-color light emission.

Alternatively, with continued reference to FIG. 2, the plurality of sub-pixels F in the display region AA of the display panel 10 emit light of different colors. For example, the plurality of sub-pixels F include first color sub-pixels F1 that emit light of a first color, second color sub-pixels F2 that emit light of a second color, and third color sub-pixels F3 that emit light of a third color, thereby realizing multi-color light emission of the display panel 10.

The first color sub-pixels F1 may be red sub-pixels that emit red light. The second sub-pixels F2 may be green sub-pixels that emit green light. The third color sub-pixels F3 may be blue sub-pixels that emit blue light.

Alternatively, the first color sub-pixels F1 may be green sub-pixels or blue sub-pixels. The second color sub-pixels F2 may be red sub-pixels or blue sub-pixels. The third color sub-pixels F3 may be red sub-pixels or green sub-pixels.

Some embodiments of the present disclosure will be schematically described below by taking an example in which the first color sub-pixels F1 are red sub-pixels, the second color sub-pixels F2 are green sub-pixels and the third color sub-pixels F3 are blue sub-pixels. However, the implementations of the present disclosure include but are not limited to this. The first color sub-pixels F1, the second color sub-pixels F2 and the third color sub-pixels F3 may also be sub-pixels F of other colors.

In some embodiments, with continued reference to FIG. 2, the display panel 10 includes a substrate 1.

For example, a material for forming the substrate 1 may include an inorganic material, e.g., a glass material such as soda-lime glass, quartz glass, or sapphire glass.

The material for forming the substrate 1 may also include an organic material, e.g., one or more of polymethyl methacrylate, polyvinyl alcohol, polyvinyl phenol, polyether sulfone, polyimide, polyamide, polyacetal, polycarbonate, polyethylene terephthalate, and polyethylene naphthalate.

The material for forming the substrate 1 may also include both an organic material and an inorganic material.

In some embodiments, with continued reference to FIG. 2, the display panel 10 further includes a pixel driving layer 2 and a light-emitting device layer 3. The pixel driving layer 2 and the light-emitting device layer 3 are located on a side of the substrate 1, and are stacked in sequence in a direction away from the substrate 1. The light-emitting device layer 3 is used for arranging the plurality of sub-pixels F of the display panel 10. The pixel driving layer 2 is used for driving the plurality of sub-pixels F in the light-emitting device layer 3 to emit light.

For example, the pixel driving layer 2 is provided therein with pixel driving circuits. A pixel driving circuit is connected to a sub-pixel F, and is used for driving the sub-pixel F to emit light.

For example, the pixel driving circuit includes a plurality of transistors. For example, the pixel driving circuit may have a structure of 3T1C, 4T1C, 5T1C, 5T2C, 6T1C, 7T1C or 8T1C. Here, "T" represents a transistor, a number preceding "T" represents the number of transistors, "C" represents a capacitor, and a number preceding "C" represents the number of capacitors.

For example, the transistors in the pixel driving circuit may be low-temperature polysilicon transistors, or may be oxide transistors, or may be low-temperature polysilicon transistors and oxide transistors. The active layer of the low-temperature polysilicon transistor adopts low-temperature polysilicon (LTPS), and the active layer of the oxide transistor adopts oxide semiconductor (Oxide). The low-temperature polysilicon transistors have the advantages of high mobility and fast charging, and the oxide transistors have the advantages of low leakage current.

For example, the transistors in the pixel driving circuit may be top-gate transistors, bottom-gate transistors or double-gate transistors.

For example, the transistors in the pixel driving circuit may be P-type transistors or N-type transistors.

For example, the pixel driving layer 2 may include: an active layer (Active) formed on the substrate 1 by a patterning process, a gate insulating layer (GI) formed on the active layer (Active) by deposition or the like, gates (Gate) of transistors (TFT) formed on the gate insulating layer (GI) by a patterning process, a dielectric layer (ILD) formed on the gates (Gate) by deposition or the like, a source-drain metal layer formed on the dielectric layer (ILD), and a planarization layer (PLN) covering the source-drain metal layer and exposing the dielectric layer (ILD); and the source-drain metal layer forms sources (Source) and drains (Drain) of the transistors (TFT).

A material of the active layer (Active) may include polysilicon and metal oxide. A material of the gate insulating layer (GI) may include an inorganic insulating material such as silicon oxide, silicon nitride or silicon oxynitride. A material of the dielectric layer (ILD) may include an inorganic insulating material such as silicon oxide, silicon nitride or silicon oxynitride. A material of the gates may include metal such as aluminum, titanium and cobalt, or an alloy material. A material of the planarization layer (PLN) may include an organic material, or may include an inorganic insulating material such as silicon oxide, silicon nitride or silicon oxynitride. The planarization layer (PLN) has a flattening effect, which is conducive to improving the quality of subsequent material deposition and reducing difference in surface of other film layers formed subsequently. The planarization layer (PLN) can block water and oxygen from entering the plurality of sub-pixels F in the light-emitting device layer 3.

For example, with continued reference to FIG. 2, the light-emitting device layer 3 includes a first electrode layer 31, a light-emitting functional layer 33 and a second electrode layer 32 that are stacked in sequence in a third direction Z (i.e. a thickness direction of the display apparatus 100). The first electrode layer 31 includes a plurality of first electrodes 311, the light-emitting functional layer 33 includes a plurality of light-emitting portions 331, and the second electrode layer 32 includes a plurality of second electrodes 321.

The first electrode layer 31 and the second electrode layer 32 may provide carriers (such as electrons and holes) to the light-emitting functional layer 33, so that the light-emitting functional layer 33 emits light. Specifically, the first electrode 311 in the first electrode layer 31 and the second electrode 321 in the second electrode layer 32 may provide carriers (such as electrons and holes) to the light-emitting portion 331 in the light-emitting functional layer 33, so that the light-emitting portion 331 in the light-emitting functional layer 33 emits light.

For example, with continued reference to FIG. 2, the first electrode layer 31 may be closer to the substrate 1 than the second electrode layer 32.

In some embodiments, with continued reference to FIG. 2, the display panel 10 further includes a pixel definition layer (PDL) 4. The pixel definition layer (PDL) 4 is located on a side of the first electrode layer 31 away from the substrate 1. The pixel definition layer (PDL) 4 is provided therein with a plurality of pixel openings, a pixel opening is arranged corresponding to a first electrode 311 in the first electrode layer 31, and each pixel opening exposes at least a portion of a first electrode 311. A light-emitting portion 331 in the light-emitting functional layer 33 is disposed in the pixel opening, and is electrically connected to both the first electrode 311 and the second electrode 321.

Since each pixel opening exposes at least a portion of a first electrode 311, the pixel definition layer (PDL) 4 may effectively define an actual effective portion of the first electrode 311 (i.e., a portion of the first electrode 311 that is directly electrically connected to the light-emitting portion 331 in the light-emitting functional layer 33), and in turn define a light-emitting region and a light-emitting area of the sub-pixel F.

In some embodiments, with continued reference to FIG. 2, the display panel 10 further includes an encapsulation structure 5. The encapsulation structure 5 is located on a side of the light-emitting device layer 3 away from the substrate 1. The encapsulation structure 5 is used for encapsulating the light-emitting device layer 3 to protect the light-emitting device layer 3 and avoid corrosion caused by external water and oxygen.

For example, with continued reference to FIG. 2, the encapsulation structure 5 is located on a side of the cover plate 20 close to the substrate 1. That is, the encapsulation structure 5 is located between the cover plate 20 and the light-emitting device layer 3.

For example, the encapsulation structure 5 may include an inorganic encapsulation layer and an organic encapsulation layer. The inorganic encapsulation layer is made of an inorganic material, which may be used for blocking water and oxygen. The organic encapsulation layer is made of an organic material, which may play the role of flattening surface, covering defects and releasing stress.

A structure of the sub-pixel F in the display panel 10 will be described in detail below.

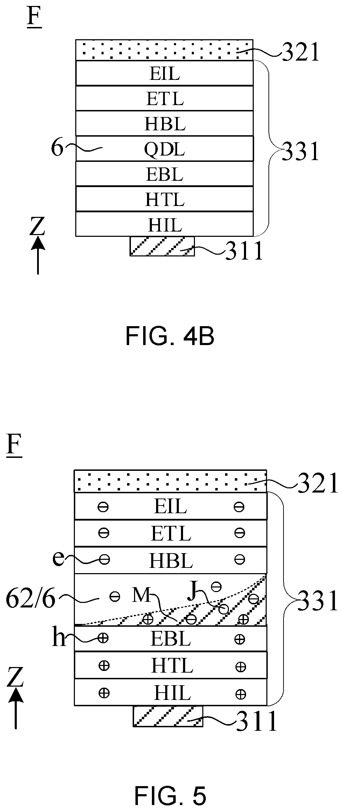

In some embodiments, as shown in FIGS. 4A and 4B, FIGS. 4A and 4B are each a diagram showing a film layer structure of a sub-pixel F in a display panel 10 according to some embodiments. The sub-pixel F includes a first electrode 311 located in the first electrode layer 31, a light-emitting portion 331 located in the light-emitting functional layer 33, and a second electrode 321 located in the second electrode layer 32. The first electrode 311, the light-emitting portion 331, and the second electrode 321 are stacked in sequence in the third direction Z (i.e., the thickness direction of the display apparatus 100). In some examples, second electrodes 321 of the plurality of sub-pixels F may be connected to each other to form a one-piece film layer structure.

For example, among the first electrode 311 and the second electrode 321, one may serve as an anode of the sub-pixel F, and the other may serve as a cathode of the sub-pixel F.

For example, the first electrode 311 may serve as the anode of the sub-pixel F. The first electrode 311 is configured to inject holes into the light-emitting portion 331. The second electrode 321 may serve as the cathode of the sub-pixel F. The second electrode 321 is configured to inject electrons into the light-emitting portion 331.

Some embodiments of the present disclosure will be schematically described below by taking an example in which the first electrode 311 serves as the anode of the sub-pixel F and the second electrode 321 is the cathode of the sub-pixel F.

For example, a material for forming the first electrode 311 may include a metal material, such as any one or more of magnesium (Mg), silver (Ag), copper (Cu), aluminum (Al), titanium (Ti), and molybdenum (Mo).

The material for forming the first electrode 311 may also include an alloy material of the above metal material, such as an aluminum-neodymium alloy (AlNd) or a molybdenum-niobium alloy (MoNb).

For example, the first electrode 311 may be of a single-layer structure.

Alternatively, the first electrode 311 may be of a multi-layer composite structure. For example, the first electrode 311 may be of a Ti/Al/Ti structure or the like. For another example, the first electrode 311 may be a stack structure formed by a metal material and a transparent conductive material, such as ITO/Ag/ITO, Mo/AlNd/ITO, etc.

For example, a material for forming the second electrode 321 may include any one or more of magnesium (Mg), silver (Ag), aluminum (Al), etc.

The material for forming the second electrode 321 may also include an alloy made of any one or more of magnesium (Mg), silver (Ag), aluminum (Al), etc.

The material for forming the second electrode 321 may also include a transparent conductive material, such as indium tin oxide (ITO).

In some embodiments, with continued reference to FIGS. 4A and 4B, the light-emitting portion 331 in the sub-pixel F includes a light-emitting layer 6. The above description "the first electrode 311 is configured to inject holes into the light-emitting portion 331" may specifically mean that the first electrode 311 is configured to inject holes into the light-emitting layer 6 in the light-emitting portion 331.

The above description "the second electrode 321 is configured to inject electrons into the light-emitting portion 331" may specifically mean that the second electrode 321 is configured to inject electrons into the light-emitting layer 6 in the light-emitting portion 331.

For example, with continued reference to FIG. 4A, the display panel 10 may be an OLED display panel. Since the display panel 10 is an OLED display panel, the light-emitting layer 6 may include an organic light-emitting layer (EML). For example, the organic light-emitting layer EML may include a light-emitting layer host material and a light-emitting layer guest material, and the light-emitting layer guest material may be a fluorescent dopant or a phosphorescent dopant.

Alternatively, with continued reference to FIG. 4B, the display panel 10 may be a QLED display panel. Since the display panel 10 is a QLED display panel, the light-emitting layer 6 may include a quantum dot layer (QDL). For example, a quantum dot layer (QDL) may have quantum dot particles, and the quantum dot particles may be interconnected via surface modifying groups.

For example, the material of the light-emitting layer 6 may include an organic material, such as toxoid compounds, perylene compounds, coumarin compounds, azacoumarin compounds, oxazole compounds, oxadiazole compounds, perinone compounds, pyrrolopyrrole compounds, naphthalene compounds, anthracene compounds, fluorene compounds, fluoranthene compounds, tetracene compounds, pyrene compounds, coronene compounds, quinolone compounds and azaquinolone compounds, pyrazoline derivatives and pyrazolone derivatives, rhodamine compounds, compounds, phenanthrene compounds, cyclopentadiene compounds, stilbene compounds, diphenylquinone compounds, styryl compounds, butadiene compounds, dicyanomethylenepyran compounds, dicyanomethylenethiopyran compounds, fluorescein compounds, pyrylium compounds, thiopyranium compounds, selenomethylene compounds, tellurium compounds, aromatic aldehyde diene compounds, oligophenylene compounds, thioxanthene compounds, cyanine compounds, acridine compounds, etc.

In some embodiments, with continued reference to FIGS. 4A and 4B, the light-emitting portion 331 in the sub-pixel F further includes one or more of a hole injection layer (HIL), a hole transport layer (HTL), an electron blocking layer (EBL), a hole blocking layer (HBL), an electron transport layer (ETL) and an electron injection layer (EIL).

The hole injection layer (HIL) may be located between the light-emitting layer 6 and the first electrode 311. The hole injection layer (HIL) has a function of promoting injection of holes from the first electrode 311 into the light-emitting layer 6. For example, the hole injection layer (HIL) may be a coating film layer, for example, may be formed by coating a solution containing a hole injection material as a solute and drying the solution. The hole injection layer (HIL) may also be an evaporated film layer, for example, may be formed by evaporating a conductive polymer material such as PSS (a mixture of polythiophene and polystyrene sulfonic acid), polyfluorene, polyfluorene derivatives, or polyarylamine, polyarylamine derivatives, or evaporating oxides of Ag, Mo, chromium (Cr), vanadium (V), tungsten (W), nickel (Ni), iridium (Ir), etc.

The hole transport layer (HTL) may be located between the light-emitting layer 6 and the first electrode 311. In the case where the light-emitting portion 331 in the sub-pixel F includes the hole injection layer (HIL), the hole transport layer (HTL) may be located between the hole injection layer (HIL) and the light-emitting layer 6. The hole transport layer (HTL) has a function of transporting holes injected from the hole injection layer (HIL) to the light-emitting layer 6. For example, the hole transport layer (HTL) may be a coating film layer, for example, may be formed by coating a solution with a hole transport material as a solute and drying the solution. The hole transport layer (HTL) may also be an evaporated film layer, for example, may be formed by evaporating a polymer compound such as polyfluorene, polyfluorene derivatives, or polyarylamine, polyarylamine derivatives, etc.

The electron blocking layer (EBL) may be located between the light-emitting layer 6 and the first electrode 311. In the case where the light-emitting portion 331 in the sub-pixel F includes the hole transport layer (HTL), the electron blocking layer (EBL) may be located between the hole transport layer (HTL) and the light-emitting layer 6.

The electron injection layer (EIL) may be located between the light-emitting layer 6 and the second electrode 321. The electron injection layer (EIL) has a function of injecting electrons supplied from the second electrode 321 into the light-emitting layer 6. For example, the electron injection layer (EIL) includes an organic material with high electron transportability, and an alkali metal, an alkaline earth metal, or a lanthanide element doped in the organic material with high electron transport capability. For example, the organic material in the electron injection layer (EIL) may include π-electron low-molecular organic materials such as oxadiazole derivatives (OXD), triazole derivatives (TAZ), and phenanthroline derivatives (BCP or Bphen). The dopant material in the electron injection layer (EIL) may include metal monomers, fluorides (e.g., NaF), quinoline complexes (e.g., Alq3 or Liq), and the like.

The electron transport layer (ETL) may be located between the light-emitting layer 6 and the second electrode 321. In the case where the light-emitting portion 331 in the sub-pixel F includes the electron injection layer (EIL), the electron transport layer (ETL) may be located between the electron injection layer (EIL) and the light-emitting layer 6. The electron transport layer (ETL) has a function of transporting electrons from the second electrode 321 to the light-emitting layer 6. The electron transport layer (ETL) is made of an organic material with high electron transport capability. For example, the electron transport layer (ETL) includes an organic material. For example, the electron transport layer (ETL) may include π-electron low-molecular organic materials such as pyridine derivatives, pyrimidine derivatives, triazine derivatives, imidazole derivatives, oxadiazole derivatives, triazole derivatives, quinazoline derivatives, and phenanthroline derivatives.

The hole blocking layer (HBL) may be located between the light-emitting layer 6 and the second electrode 321. In the case where the light-emitting portion 331 in the sub-pixel F includes the electron transport layer (ETL), the hole blocking layer (HBL) may be located between the electron transport layer (ETL) and the light-emitting layer 6. The hole blocking layer (HBL) has a function of restricting a flow of holes from the light-emitting layer 6 to the hole blocking layer (HBL) and controlling an injection of electrons from the electron transport layer (ETL) to the light-emitting layer 6. For example, a material of the hole blocking layer (HBL) may include an organic material, such as pyridine derivatives, pyrimidine derivatives, triazine derivatives, imidazole derivatives, oxadiazole derivatives, triazole derivatives, quinazoline derivatives, phenanthroline derivatives, etc.

The light-emitting principle of the sub-pixel F will be described below.

In some embodiments, as shown in FIG. 5, FIG. 5 is a diagram showing a film layer structure of a sub-pixel F in a display panel 10 according to some embodiments. In the case where the first electrode 311 serves as the anode of the sub-pixel F and the second electrode 321 serves as the cathode of the sub-pixel F, when a voltage is applied between the first electrode 311 and the second electrode 321, holes h injected from the first electrode 311 may be transported to the light-emitting layer 6, and electrons e injected from the second electrode 321 may also be transported to the light-emitting layer 6. The electrons e and holes h serving as carriers recombine in the light-emitting layer 6 to generate excitons J, and when the excitons J jump from an excited state to a ground state, light will be emitted. A region where the electrons e and the holes h recombine may be called a recombination region (i.e. a light-emitting region) M.

In some embodiments, with continued reference to FIG. 5, the light-emitting layer 6 is a second light-emitting layer 62. In the case where the light-emitting layer 6 is the second light-emitting layer 62, the first electrode 311 is configured to inject holes into the second light-emitting layer 62, and the second electrode 321 is configured to inject electrons into the second light-emitting layer 62. The second light-emitting layer 62 is of a single-layer structure.

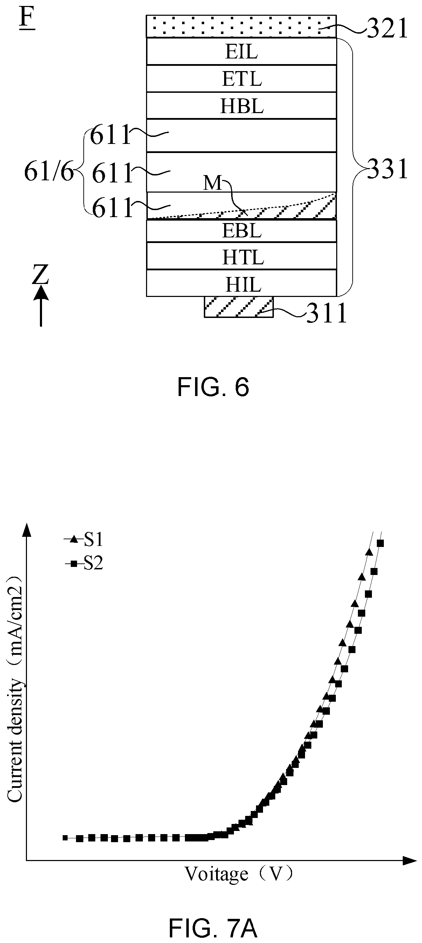

In some other embodiments, as shown in FIG. 6, FIG. 6 is a diagram showing a film layer structure of a sub-pixel F in a display panel 10 according to some embodiments. The light-emitting layer 6 is a first light-emitting layer 61. In the case where the light-emitting layer 6 is the first light-emitting layer 61, the first electrode 311 is configured to inject holes into the first light-emitting layer 61, and the second electrode 321 is configured to inject electrons into the first light-emitting layer 61.

The first light-emitting layer 61 includes at least two light-emitting sub-layers 611 that are stacked. Hole mobility of each light-emitting sub-layer 611 in the first light-emitting layer 61 is less than electron mobility of the light-emitting sub-layer 611.

Since the first light-emitting layer 61 includes at least two light-emitting sub-layers 611 that are stacked and the hole mobility of each light-emitting sub-layer 611 in the first light-emitting layer 61 is less than the electron mobility of the light-emitting sub-layer 611, that is, each light-emitting sub-layer 611 in the first light-emitting layer 61 has larger electron mobility and smaller hole mobility, it facilitates transporting the electrons e injected by the second electrode 321 to light-emitting sub-layer(s) 611 in the first light-emitting layer 61 that are relatively close to the first electrode 311, and it may avoid that the holes h injected by the first electrode 311 are excessively transported to light-emitting sub-layer(s) 611 in the first light-emitting layer 61 that are relatively far away from the first electrode 311, and is beneficial for the recombination of the holes h and the electrons e in the light-emitting sub-layer(s) 611 in the first light-emitting layer 61 that are relatively close to the first electrode 311. Therefore, the recombination region (i.e., the light-emitting region) M of the first light-emitting layer 61 may be mostly or entirely located in the light-emitting sub-layer(s) 611 in the first light-emitting layer 61 that are relatively close to the first electrode 311, which may reduce the recombination region (i.e., the light-emitting region) M of the first light-emitting layer 61. Thus, the recombination region (i.e., the light-emitting region) M of the first light-emitting layer 61 is smaller than the recombination region (i.e., the light-emitting region) M of the second light-emitting layer 62 of the single-layer structure in the embodiment shown in FIG. 5, which facilitates the recombination of electrons e and holes h serving as carriers in the recombination region (i.e., the light-emitting region) M in the first light-emitting layer 61, which is conducive to improving the recombination efficiency of electrons e and holes h in the first light-emitting layer 61.

It will be noted that FIG. 6 only shows an example where the number of stacked light-emitting sub-layers 611 in the first light-emitting layer 61 is three. The number of stacked light-emitting sub-layers 611 in the first light-emitting layer 61 includes but is not limited to this. For example, the number of stacked light-emitting sub-layers 611 in the first light-emitting layer 61 may be two, four, five or six.

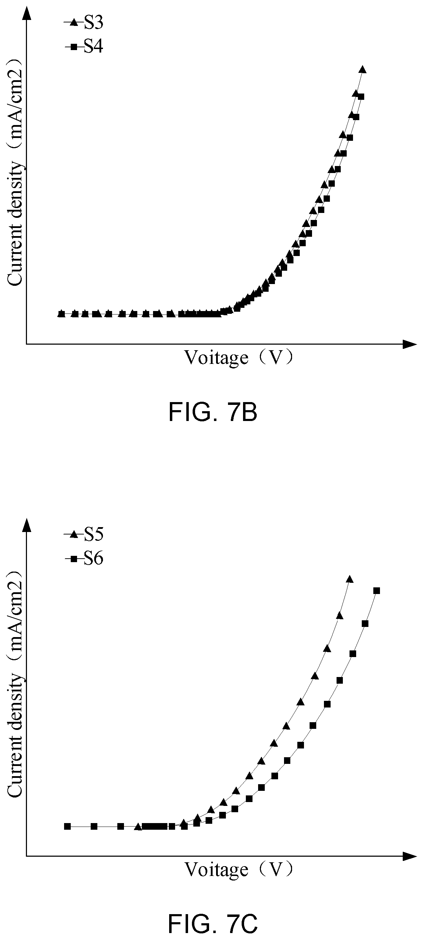

In the case where the plurality of sub-pixels F in the display panel 10 include first color sub-pixels F1, second color sub-pixels F2, and third color sub-pixels F3, and the first color sub-pixels F1 are red sub-pixels, the second color sub-pixel F2 are green sub-pixels, and the third color sub-pixels F3 are blue sub-pixels, as shown in FIGS. 7A, 7B, and 7C, FIG. 7A is a graph showing a corresponding relationship between voltage and current density of a first color sub-pixel (i.e. a red sub-pixel) F1 in a display panel 10, FIG. 7B is a graph showing a corresponding relationship between voltage and current density of a second color sub-pixel (i.e. a green sub-pixel) F2 in a display panel 10, and FIG. 7C is a graph showing a corresponding relationship between voltage and current density of a third color sub-pixel (i.e. a blue sub-pixel) F3 in a display panel 10.

With continued reference to FIG. 7A, in which the horizontal axis is the operating voltage (Voltage) of the first color sub-pixel (i.e. red sub-pixel) F1, and the vertical axis is the current density (Current Density) of the first color sub-pixel (i.e. red sub-pixel) F1. The curve S1 is a curve of a corresponding relationship between the operating voltage (Voltage) and the current density (Current Density) of the first color sub-pixel F1 including the first light-emitting layer 61, and the curve S2 is a curve of a corresponding relationship between the operating voltage (Voltage) and the current density (Current Density) of the first color sub-pixel F1 including the second light-emitting layer 62.

When the first color sub-pixels F1 require the same current density (Current Density), the operating voltage (Voltage) of the first color sub-pixel F1 including the first light-emitting layer 61 is less than the operating voltage (Voltage) of the first color sub-pixel F1 including the second light-emitting layer 62. That is to say, the operating voltage (Voltage) of the first color sub-pixel F1 including the first light-emitting layer 61 is smaller than the operating voltage (Voltage) of the first color sub-pixel F1 including the second light-emitting layer 62. Therefore, when the first color sub-pixel F1 in the display panel 10 is the first color sub-pixel F1 including the first light-emitting layer 61, it may be possible to reduce the bias voltage required by the display panel 10.

With continued reference to FIG. 7B, in which the horizontal axis is the operating voltage (Voltage) of the second color sub-pixel (i.e. green sub-pixel) F2, and the vertical axis is the current density (Current Density) of the second color sub-pixel (i.e. green sub-pixel) F2. The curve S3 is a curve of a corresponding relationship between the operating voltage (Voltage) and the current density (Current Density) of the second color sub-pixel F2 including the first light-emitting layer 61, and the curve S4 is a curve of a corresponding relationship between the operating voltage (Voltage) and the current density (Current Density) of the second color sub-pixel F2 including the second light-emitting layer 62.

When the second color sub-pixels F2 require the same current density (Current Density), the operating voltage (Voltage) of the second color sub-pixel F2 including the first light-emitting layer 61 is less than the operating voltage (Voltage) of the second color sub-pixel F2 including the second light-emitting layer 62. That is to say, the operating voltage (Voltage) of the second color sub-pixel F2 including the first light-emitting layer 61 is smaller than the operating voltage (Voltage) of the second color sub-pixel F2 including the second light-emitting layer 62. Therefore, when the second color sub-pixel F2 in the display panel 10 is the second color sub-pixel F2 including the first light-emitting layer 61, it may be possible to reduce the bias voltage required by the display panel 10.

With continued reference to FIG. 7C, in which the horizontal axis is the operating voltage (Voltage) of the third color sub-pixel (i.e. blue sub-pixel) F3, and the vertical axis is the current density (Current Density) of the third color sub-pixel (i.e. blue sub-pixel) F3.

The curve S5 is a curve of a corresponding relationship between the operating voltage (Voltage) and the current density (Current Density) of the third color sub-pixel F3 including the first light-emitting layer 61, and the curve S6 is a curve of a corresponding relationship between the operating voltage (Voltage) and the current density (Current Density) of the third color sub-pixel F3 including the second light-emitting layer 62.

When the third color sub-pixels F3 require the same current density (Current Density), the operating voltage (Voltage) of the third color sub-pixel F3 including the first light-emitting layer 61 is less than the operating voltage (Voltage) of the third color sub-pixel F3 including the second light-emitting layer 62. That is to say, the operating voltage (Voltage) of the third color sub-pixel F3 including the first light-emitting layer 61 is smaller than the operating voltage (Voltage) of the third color sub-pixel F3 including the second light-emitting layer 62. Therefore, when the third color sub-pixel F3 in the display panel 10 is the third color sub-pixel F3 including the first light-emitting layer 61, it may be possible to reduce the bias voltage required by the display panel 10.

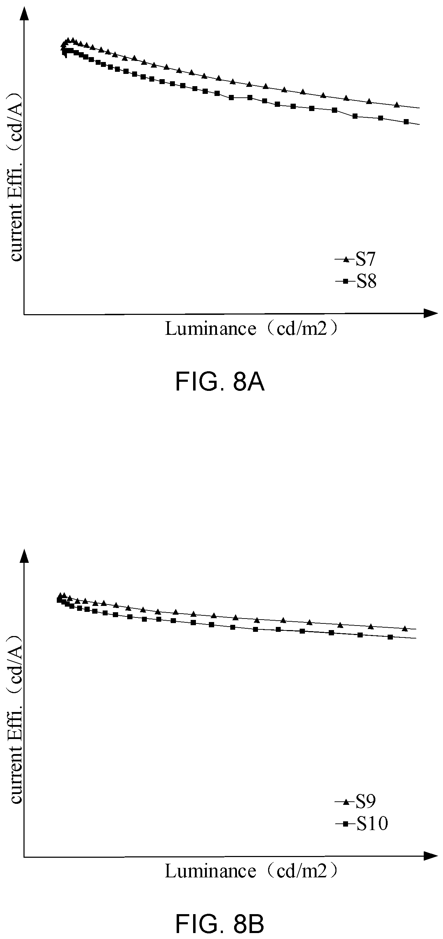

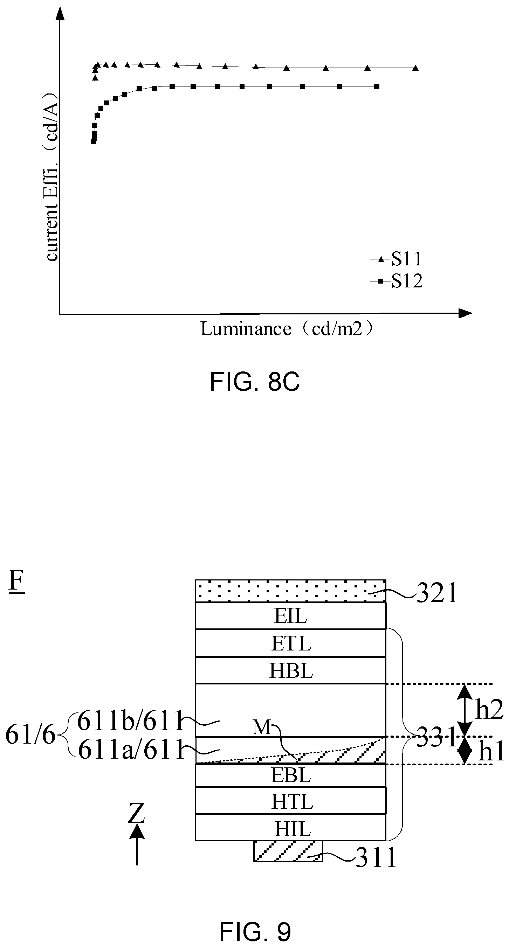

As shown in FIGS. 8A, 8B and 8C, FIG. 8A is a graph showing a corresponding relationship between luminance and efficiency of a first color sub-pixel (i.e. a red sub-pixel) F1 in a display panel 10, FIG. 8B is a graph showing a corresponding relationship between luminance and efficiency of a second color sub-pixel (i.e. a green sub-pixel) F2 in a display panel 10, and FIG. 8C is a graph showing a corresponding relationship between luminance and efficiency of a third color sub-pixel (i.e. a blue sub-pixel) F3 in a display panel 10.

With continued reference to FIG. 8A, in which the horizontal axis is the luminance (Luminance) of the first color sub-pixel (i.e., red sub-pixel) F1, and the vertical axis is the efficiency (Current Effi) of the first color sub-pixel (i.e., red sub-pixel) F1. The curve S7 is a curve of a corresponding relationship between the luminance (Luminance) and the efficiency (Current Effi) of the first color sub-pixel F1 including the first light-emitting layer 61, and the curve S8 is a curve of a corresponding relationship between the luminance (Luminance) and the efficiency (Current Effi) of the first color sub-pixel F1 including the second light-emitting layer 62.

When the first color sub-pixels F1 have the same luminance (Luminance), the efficiency (Current Effi) of the first color sub-pixel F1 including the first light-emitting layer 61 is greater than the efficiency (Current Effi) of the first color sub-pixel F1 including the second light-emitting layer 62. That is to say, the efficiency (Current Effi) of the first color sub-pixel F1 including the first light-emitting layer 61 is higher than the efficiency (Current Effi) of the first color sub-pixel F1 including the second light-emitting layer 62. Therefore, when the first color sub-pixel F1 in the display panel 10 is the first color sub-pixel F1 including the first light-emitting layer 61, the light-emitting efficiency and performance of the display panel 10 may be improved.

With continued reference to FIG. 8B, in which the horizontal axis is the luminance (Luminance) of the second color sub-pixel (i.e. green sub-pixel) F2, and the vertical axis is the efficiency (Current Effi) of the second color sub-pixel (i.e. green sub-pixel) F2. The curve S9 is a curve of a corresponding relationship between the luminance (Luminance) and the efficiency (Current Effi) of the second color sub-pixel F2 including the first light-emitting layer 61, and the curve S10 is a curve of a corresponding relationship between the luminance (Luminance) and the efficiency (Current Effi) of the second color sub-pixel F2 including the second light-emitting layer 62.

When the second color sub-pixels F2 have the same luminance (Luminance), the efficiency (Current Effi) of the second color sub-pixel F2 including the first light-emitting layer 61 is greater than the efficiency (Current Effi) of the second color sub-pixel F2 including the second light-emitting layer 62. That is to say, the efficiency (Current Effi) of the second color sub-pixel F2 including the first light-emitting layer 61 is higher than the efficiency (Current Effi) of the second color sub-pixel F2 including the second light-emitting layer 62. Therefore, when the second color sub-pixel F2 in the display panel 10 is the second color sub-pixel F2 including the first light-emitting layer 61, the light-emitting efficiency and performance of the display panel 10 may be improved.

With continued reference to FIG. 8C, in which the horizontal axis is the luminance (Luminance) of the third color sub-pixel (i.e. blue sub-pixel) F3, and the vertical axis is the efficiency (Current Effi) of the third color sub-pixel (i.e. blue sub-pixel) F3. The curve S11 is a curve of a corresponding relationship between the luminance (Luminance) and the efficiency (Current Effi) of the third color sub-pixel F3 including the first light-emitting layer 61, and the curve S12 is a curve of a corresponding relationship between the luminance (Luminance) and the efficiency (Current Effi) of the third color sub-pixel F3 including the second light-emitting layer 62.

When the third color sub-pixels F3 have the same luminance (Luminance), the efficiency (Current Effi) of the third color sub-pixel F3 including the first light-emitting layer 61 is greater than the efficiency (Current Effi) of the third color sub-pixel F3 including the second light-emitting layer 62. That is to say, the efficiency (Current Effi) of the third color sub-pixel F3 including the first light-emitting layer 61 is higher than the efficiency (Current Effi) of the third color sub-pixel F3 including the second light-emitting layer 62. Therefore, when the third color sub-pixel F3 in the display panel 10 is the third color sub-pixel F3 including the first light-emitting layer 61, the light-emitting efficiency and performance of the display panel 10 may be improved.

In summary, compared to the sub-pixel F in the display panel 10 being the sub-pixel F (e.g., the first color sub-pixel F1, the second color sub-pixel F2, and the third color sub-pixel F3) including the second light-emitting layer 62, when the sub-pixel F in the display panel 10 is the sub-pixel F (e.g., the first color sub-pixel F1, the second color sub-pixel F2, and the third color sub-pixel F3) including the first light-emitting layer 61, the bias voltage required for the display panel 10 may be reduced, and the light-emitting efficiency and performance of the display panel 10 may be improved.

For example, the first light-emitting layer 61 includes an organic light-emitting layer (EML). The light-emitting layer guest materials (e.g., fluorescent dopants or phosphorescent dopants) included in the at least two light-emitting sub-layers 611 in the first light-emitting layer 61 may be the same or different.

For example, a ratio of the electron mobility to the hole mobility of each light-emitting sub-layer 611 in the first light-emitting layer 61 is greater than or equal to 10.

Since the ratio of the electron mobility to the hole mobility of each light-emitting sub-layer 611 in the first light-emitting layer 61 is greater than or equal to 10, that is, the electron mobility of each light-emitting sub-layer 611 in the first light-emitting layer 61 is much greater than the hole mobility, it is convenient for the electrons injected by the second electrode 321 to be transported to the light-emitting sub-layer 611 in the first light-emitting layer 61 that is relatively close to the first electrode 311, and it may be possible to greatly avoid that the holes injected by the first electrode 311 are excessively transported to the light-emitting sub-layer 611 in the first light-emitting layer 61 that is relatively far away from the first electrode 311. Furthermore, the recombination region (i.e., the light-emitting region) M of the first light-emitting layer 61 may be mostly or entirely located in the light-emitting sub-layer 611 in the first light-emitting layer 61 that is relatively close to the first electrode 311, which may reduce the recombination region (i.e., the light-emitting region) M of the first light-emitting layer 61 and improve the recombination efficiency of electrons and holes in the light-emitting sub-layer 611 that is relatively close to the first electrode 311 (injecting holes) in the first light-emitting layer 61. Moreover, the bias voltage required for the display panel 10 is reduced, and the light-emitting efficiency and performance of the display panel 10 is improved.

The configuration of the electron mobility of the at least two light-emitting sub-layers 611 in the first light-emitting layer 61 will be described below.

In some embodiments, as shown in FIG. 9, FIG. 9 is a diagram showing a film layer structure of a sub-pixel F in a display panel 10 according to some embodiments. The first light-emitting layer 61 includes a first light-emitting sub-layer 611a and a second light-emitting sub-layer 611b adjacent to the first light-emitting sub-layer 611a. The first light-emitting sub-layer 611a is closer to the first electrode 311 than the second light-emitting sub-layer 611b. The electron mobility of the second light-emitting sub-layer 611b is greater than the electron mobility of the first light-emitting sub-layer 611a.

It will be understood that FIG. 9 shows the case where the first light-emitting layer 61 includes two light-emitting sub-layers 611. In other embodiments, the first light-emitting layer 61 may include three or even more light-emitting sub-layers 611. Among these light-emitting sub-layers 611, the first light-emitting sub-layer 611a and the second light-emitting sub-layer 611b are closer to the first electrode 311 than other light-emitting sub-layers 611.

The first light-emitting layer 61 include the first light-emitting sub-layer 611a and the second light-emitting sub-layer 611b adjacent to the first light-emitting sub-layer 611a, the first light-emitting sub-layer 611a is closer to the first electrode 311 than the second light-emitting sub-layer 611b, and the electron mobility of the second light-emitting sub-layer 611b in the first light-emitting layer 61 is greater than the electron mobility of the first light-emitting sub-layer 611a in the first light-emitting layer 61. Therefore, the injection barrier of electrons transmitted from the second light-emitting sub-layer 611b to the first light-emitting sub-layer 611a may be increased, which prevents the electrons from being transmitted from the second light-emitting sub-layer 611b to the first light-emitting sub-layer 611a too quickly; and it is beneficial to protecting the electron blocking layer (EBL) located on the side of the first light-emitting sub-layer 611a away from the second light-emitting sub-layer 611b, avoids failure of the electron blocking layer (EBL), and is conducive to improving the service life of the display panel 10.

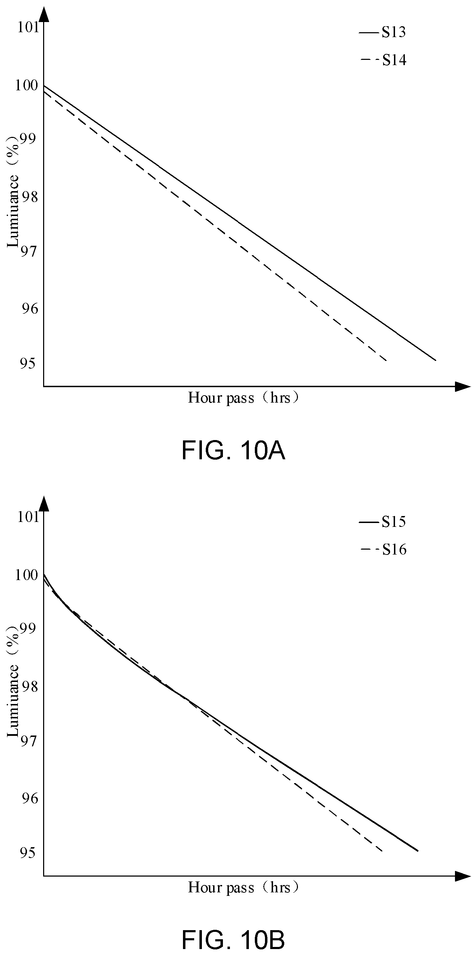

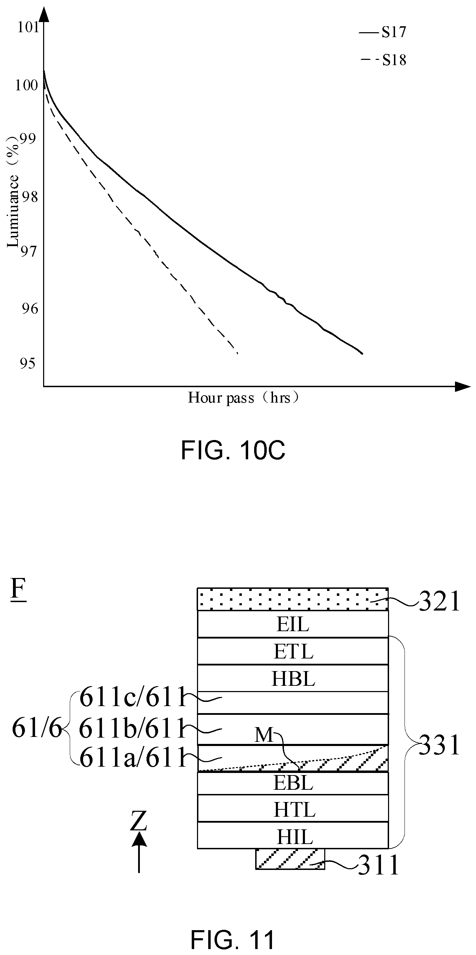

In the case where the plurality of sub-pixels F in the display panel 10 include first color sub-pixels F1, second color sub-pixels F2, and third color sub-pixels F3, and the first color sub-pixels F1 are red sub-pixels, the second color sub-pixel F2 are green sub-pixels, and the third color sub-pixels F3 are blue sub-pixels, as shown in FIGS. 10A, 10B, and 10C, FIG. 10A is a graph showing a corresponding relationship between usage time and luminance of a first color sub-pixel (i.e. a red sub-pixel) F1 in a display panel 10, FIG. 10B is a graph showing a corresponding relationship between usage time and luminance of a second color sub-pixel (i.e. a green sub-pixel) F2 in a display panel 10, and FIG. 10C is a graph showing a corresponding relationship between usage time and luminance of a third color sub-pixel (i.e. a blue sub-pixel) F3 in a display panel 10.

With continued reference to FIG. 10A, in which the horizontal axis is the usage time (Hour Pass) of the first color sub-pixel (i.e., red sub-pixel) F1, and the vertical axis is the luminance (Luminance) of the first color sub-pixel (i.e., red sub-pixel) F1. The curve S13 is a curve of a corresponding relationship between the usage time (Hour Pass) and the luminance (Luminance) of the first color sub-pixel F1 including the first light-emitting layer 61, and the electron mobility of the second light-emitting sub-layer 611b in the first light-emitting layer 61 is greater than the electron mobility of the first light-emitting sub-layer 611a in the first light-emitting layer 61. The curve S14 is a curve of a corresponding relationship between the usage time (Hour Pass) and the luminance (Luminance) of the first color sub-pixel F1 including the second light-emitting layer 62.

When the first color sub-pixels F1 have the same luminance, the usage time of the first color sub-pixel F1 including the first light-emitting layer 61 is greater than the usage time of the first color sub-pixel F1 including the second light-emitting layer 62. That is to say, the first color sub-pixel F1 including the first light-emitting layer 61 has a longer service life than the first color sub-pixel F1 including the second light-emitting layer 62. Therefore, when the first color sub-pixel F1 in the display panel 10 is the first color sub-pixel F1 including the first light-emitting layer 61 and the electron mobility of the second light-emitting sub-layer 611b in the first light-emitting layer 61 is greater than the electron mobility of the first light-emitting sub-layer 611a in the first light-emitting layer 61, the service life of the display panel 10 may be extended.

With continued reference to FIG. 10B, in which the horizontal axis is the usage time (Hour Pass) of the second color sub-pixel (i.e., green sub-pixel) F2, and the vertical axis is the luminance (Luminance) of the second color sub-pixel (i.e., green sub-pixel) F2. The curve S15 is a curve of a corresponding relationship between the usage time (Hour Pass) and the luminance (Luminance) of the second color sub-pixel F2 including the first light-emitting layer 61, and the electron mobility of the second light-emitting sub-layer 611b in the first light-emitting layer 61 is greater than the electron mobility of the first light-emitting sub-layer 611a in the first light-emitting layer 61. The curve S16 is a curve of a corresponding relationship between the usage time (Hour Pass) and the luminance (Luminance) of the second color sub-pixel F2 including the second light-emitting layer 62.

When the second color sub-pixels F2 have the same luminance, the usage time (Hour Pass) of the second color sub-pixel F2 including the first light-emitting layer 61 is greater than the usage time (Hour Pass) of the second color sub-pixel F2 including the second light-emitting layer 62. That is to say, the second color sub-pixel F2 including the first light-emitting layer 61 has a longer service life than the second color sub-pixel F2 including the second light-emitting layer 62. Therefore, when the second color sub-pixel F2 in the display panel 10 is the second color sub-pixel F2 including the first light-emitting layer 61 and the electron mobility of the second light-emitting sub-layer 611b in the first light-emitting layer 61 is greater than the electron mobility of the first light-emitting sub-layer 611a in the first light-emitting layer 61, the service life of the display panel 10 may be extended.

With continued reference to FIG. 10C, in which the horizontal axis is the usage time (Hour Pass) of the third color sub-pixel (i.e. blue sub-pixel) F3, and the vertical axis is the luminance (Luminance) of the third color sub-pixel (i.e. blue sub-pixel) F3. The curve S17 is a curve of a corresponding relationship between the usage time (Hour Pass) and the luminance (Luminance) of the third color sub-pixel F3 including the first light-emitting layer 61, and the electron mobility of the second light-emitting sub-layer 611b in the first light-emitting layer 61 is greater than the electron mobility of the first light-emitting sub-layer 611a in the first light-emitting layer 61. The curve S18 is a curve of a corresponding relationship between the usage time (Hour Pass) and the luminance (Luminance) of the third color sub-pixel F3 including the second light-emitting layer 62.

When the third color sub-pixels F3 have the same luminance, the usage time (Hour Pass) of the third color sub-pixel F3 including the first light-emitting layer 61 is greater than the usage time (Hour Pass) of the third color sub-pixel F3 including the second light-emitting layer 62. That is to say, the third color sub-pixel F3 including the first light-emitting layer 61 has a longer service life than the third color sub-pixel F3 including the second light-emitting layer 62. Therefore, when the third color sub-pixel F3 in the display panel 10 is the third color sub-pixel F3 including the first light-emitting layer 61 and the electron mobility of the second light-emitting sub-layer 611b in the first light-emitting layer 61 is greater than the electron mobility of the first light-emitting sub-layer 611a in the first light-emitting layer 61, the service life of the display panel 10 may be extended.

In some embodiments, as shown in FIG. 11, FIG. 11 is a diagram showing a film layer structure of a sub-pixel F in a display panel 10 according to some embodiments. The first light-emitting layer 61 includes at least three light-emitting sub-layers 611. In a direction from the first electrode 311 to the second electrode 321, electron mobility of the at least three light-emitting sub-layers 611 in the first light-emitting layer 61 increases sequentially.

For example, with continued reference to FIG. 11, the first light-emitting layer 61 may include three light-emitting sub-layers 611.

Alternatively, the first light-emitting layer 61 may include four light-emitting sub-layers 611.

Alternatively, the first light-emitting layer 61 may include five light-emitting sub-layers 611.

Alternatively, the first light-emitting layer 61 may include six light-emitting sub-layers 611.

Considering an example in which the first light-emitting layer 61 may include three light-emitting sub-layers 611, with continued reference to FIG. 11, the first light-emitting layer 61 includes a first light-emitting sub-layer 611a, a second light-emitting sub-layer 611b and a third light-emitting sub-layer 611c. The first light-emitting sub-layer 611a, the second light-emitting sub-layer 611b and the third light-emitting sub-layer 611c are stacked in sequence in the direction from the first electrode 311 to the second electrode 321. That is, the first light-emitting sub-layer 611a is closer to the first electrode 311 than the third light-emitting sub-layer 611c, and the second light-emitting sub-layer 611b is located between the first light-emitting sub-layer 611a and the second light-emitting sub-layer 611b.

Since the first light-emitting layer 61 includes three light-emitting sub-layers 611 (i.e., the first light-emitting sub-layer 611a, the second light-emitting sub-layer 611b and the third light-emitting sub-layer 611c), the above description " in the direction from the first electrode 311 to the second electrode 321, the electron mobility of the at least three light-emitting sub-layers 611 in the first light-emitting layer 61 increases sequentially" means that the electron mobility of the first light-emitting sub-layer 611a, the electron mobility of the second light-emitting sub-layer 611b and the electron mobility of the third light-emitting sub-layer 611c increase sequentially. That is, the electron mobility of the first light-emitting sub-layer 611a is less than the electron mobility of the second light-emitting sub-layer 611b and is less than the electron mobility of the third light-emitting sub-layer 611c, and the electron mobility of the second light-emitting sub-layer 611b is less than the electron mobility of the third light-emitting sub-layer 611c.

Since the electron mobility of the first light-emitting sub-layer 611a, the electron mobility of the second light-emitting sub-layer 611b and the electron mobility of the third light-emitting sub-layer 611c increase in sequence, when electrons pass from the third light-emitting sub-layer 611c to the first light-emitting sub-layer 611a through the second light-emitting sub-layer 611b, the injection barrier of electrons transmitted from the second light-emitting sub-layer 611b to the first light-emitting sub-layer 611a may be increased, which prevents electrons from being transmitted from the second light-emitting sub-layer 611b to the first light-emitting sub-layer 611a too quickly. The injection barrier of electrons transmitted from the third light-emitting sub-layer 611c to the second light-emitting sub-layer 611b may also be increased, which prevents electrons from being transmitted from the third light-emitting sub-layer 611c to the second light-emitting sub-layer 611b too quickly. It is beneficial for further protecting the electron blocking layer (EBL) located on a side of the first light-emitting sub-layer 611a away from the second light-emitting sub-layer 611b, avoids the failure of the electron blocking layer (EBL), and further improves the service life of the display panel 10.

The configuration of the hole mobility of the at least two light-emitting sub-layers 611 in the first light-emitting layer 61 will be described below.

In some embodiments, with continued reference to FIG. 9, the first light-emitting layer 61 includes the first light-emitting sub-layer 611a and the second light-emitting sub-layer 611b adjacent to the first light-emitting sub-layer 611a, the first light-emitting sub-layer 611a is closer to the first electrode 311 than the second light-emitting sub-layer 611b, and the hole mobility of the second light-emitting sub-layer 611b is greater than or equal to the hole mobility of the first light-emitting sub-layer 611a. That is, the hole mobility of the first light-emitting sub-layer 611a is the same as the hole mobility of the second light-emitting sub-layer 611b, or the hole mobility of the first light-emitting sub-layer 611a is less than the hole mobility of the second light-emitting sub-layer 611b.

In the case where the hole mobility of the first light-emitting sub-layer 611a is the same as the hole mobility of the second light-emitting sub-layer 611b, the hole mobility of each light-emitting sub-layer 611 in the first light-emitting layer 61 is less than the electron mobility of the light-emitting sub-layer 611. That is, the hole mobility of the first light-emitting sub-layer 611a is less than the electron mobility of the first light-emitting sub-layer 611a, and the hole mobility of the second light-emitting sub-layer 611b is less than the electron mobility of the second light-emitting sub-layer 611b. That is to say, electrons are transmitted faster in the first light-emitting sub-layer 611a and the second light-emitting sub-layer 611b, and holes are transmitted slower in the first light-emitting sub-layer 611a and the second light-emitting sub-layer 611b. Therefore, even if the hole mobility of the first light-emitting sub-layer 611a and the hole mobility of the second light-emitting sub-layer 611b are the same, it is possible to avoid that holes injected by the first electrode 311 are excessively transported to a light-emitting sub-layer 611 in the first light-emitting layer 61 other than the first light-emitting sub-layer 611a, which facilitates the recombination of holes and electrons in the first light-emitting sub-layer 61a in the first light-emitting layer 61, and improves the recombination efficiency of electrons and holes in the first light-emitting layer 61.

In the case where the hole mobility of the first light-emitting sub-layer 611a is less than the hole mobility of the second light-emitting sub-layer 611b, holes are transmitted slower in the first light-emitting sub-layer 611a and transmitted faster in the second light-emitting sub-layer 611b, which may further avoid that holes injected by the first electrode 311 are excessively transported to a light-emitting sub-layer 611 (e.g. the second light-emitting sub-layer 611b) in the first light-emitting layer 61 other than the first light-emitting sub-layer 611a, which facilitates the recombination of holes and electrons in the first light-emitting sub-layer 61a in the first light-emitting layer 61, and further improves the recombination efficiency of electrons and holes in the first light-emitting layer 61.

In some embodiments, with continued reference to FIG. 11, the first light-emitting layer 61 includes at least three light-emitting sub-layers 611 (for example, the first light-emitting sub-layer 611a, the second light-emitting sub-layer 611b and the third light-emitting sub-layer 611c), and in the direction from the first electrode 311 to the second electrode 321, the hole mobility of the at least three light-emitting sub-layers 611 increases sequentially.

Considering an example in which the first light-emitting layer 61 may include three light-emitting sub-layers 611, the above description "in the direction from the first electrode 311 to the second electrode 321, the hole mobility of the at least three light-emitting sub-layers 611 in the first light-emitting layer 61 increases sequentially" means that the hole mobility of the first light-emitting sub-layer 611a, the hole mobility of the second light-emitting sub-layer 611b and the hole mobility of the third light-emitting sub-layer 611c increase sequentially. That is, the hole mobility of the first light-emitting sub-layer 611a is less than the hole mobility of the second light-emitting sub-layer 611b and is less than the hole mobility of the third light-emitting sub-layer 611c, and the hole mobility of the second light-emitting sub-layer 611b is less than the hole mobility of the third light-emitting sub-layer 611c.

Since the hole mobility of the first light-emitting sub-layer 611a, the hole mobility of the second light-emitting sub-layer 611b and the hole mobility of the third light-emitting sub-layer 611c increase sequentially, the hole transmission rates of the first light-emitting sub-layer 611a, the second light-emitting sub-layer 611b and the third light-emitting sub-layer 611c are slowed down in sequence, which may further avoid that holes injected by the first electrode 311 are excessively transported to light-emitting sub-layers 611 (e.g. the second light-emitting sub-layer 611b and the third light-emitting sub-layer 611c) in the first light-emitting layer 61 other than the first light-emitting sub-layer 611a, which facilitates the recombination of holes and electrons in the first light-emitting sub-layer 61a in the first light-emitting layer 61, and further improves the recombination efficiency of electrons and holes in the first light-emitting layer 61.

The configuration of thicknesses of the at least two light-emitting sub-layers 611 in the first light-emitting layer 61 will be described below.

In some embodiments, with continued reference to FIG. 9, the first light-emitting layer 61 includes the first light-emitting sub-layer 611a and the second light-emitting sub-layer 611b adjacent to the first light-emitting sub-layer 611a, and the first light-emitting sub-layer 611a is closer to the first electrode 311 than the second light-emitting sub-layer 611b. The thickness h1 of the first light-emitting sub-layer 611a in the first light-emitting layer 61 is less than the thickness h2 of the second light-emitting sub-layer 611b in the first light-emitting layer 61.

For example, the thickness h1 of the first light-emitting sub-layer 611a in the first light-emitting layer 61 may be in a range of 5 nm to 10 nm.

For example, the thickness h1 of the first light-emitting sub-layer 611a in the first light-emitting layer 61 may be 5 nm, 5.5 nm, 6 nm, 6.5 nm, 7 nm, 7.5 nm, 8 nm, 8.5 nm, 9 nm, 9.5 nm or 10 nm.

It will be noted that the above description "the thickness h1 of the first light-emitting sub-layer 611a in the first light-emitting layer 61" refers to a dimension h1 of the first light-emitting sub-layer 611a in the first light-emitting layer 61 in the third direction Z (i.e. the thickness direction of the display apparatus 100). The above description "the thickness h2 of the second light-emitting sub-layer 611b in the first light-emitting layer 61" refers to a dimension h2 of the second light-emitting sub-layer 611b in the first light-emitting layer 61 in the third direction Z (i.e., the thickness direction of the display apparatus 100). The following descriptions of "the thickness h1 of the first light-emitting sub-layer 611a in the first light-emitting layer 61" and "the thickness h2 of the second light-emitting sub-layer 611b in the first light-emitting layer 61" also follow the explanations here, and details will not be repeated.

The configuration of the lowest unoccupied molecular orbital (LUMO) energy level and the highest occupied molecular orbital (HOMO) energy level of the film layers in the sub-pixel F of the display panel 10 will be described below.

It will be noted that the lowest unoccupied molecular orbital (LUMO) energy level represents the orbital with the lowest energy level that is not occupied by electrons and has a higher affinity for electrons. The highest occupied molecular orbital (HOMO) energy level represents the orbital with the highest energy level occupied by electrons. Since the highest occupied molecular orbital (HOMO) energy level already contains electrons, the higher the highest occupied molecular orbital (HOMO) energy level, the higher its electron ionization potential is, and it is more conducive to receiving injected holes.

In the following description, the lowest unoccupied molecular orbital (LUMO) energy level and the highest occupied molecular orbital (HOMO) energy level of the film layer in the sub-pixel F refer to energy levels of an organic material for forming the film layer. When the film layer of the sub-pixel F includes various organic materials, an energy level of a representative organic material in the film layer responsible for the transmission of electrons or holes is referred to as the lowest unoccupied molecular orbital (LUMO) energy level or the highest occupied molecular orbital (HOMO) energy level of the film layer.

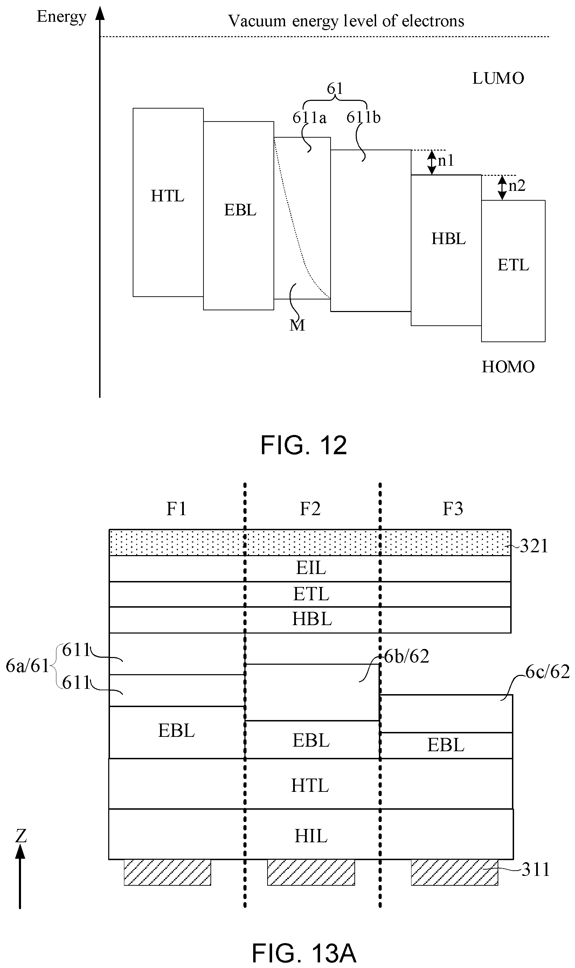

In some embodiments, as shown in FIG. 12, FIG. 12 is a schematic diagram of lowest unoccupied molecular orbital (LUMO) energy levels and highest occupied molecular orbital (HOMO) energy levels of film layers of a sub-pixel F in a display panel 10 according to some embodiments.

It will be noted that FIG. 12 only shows the lowest unoccupied molecular orbital (LUMO) energy levels and the highest occupied molecular orbital (HOMO) energy levels of the hole transport layer (HTL), the electron blocking layer (EBL), the first light-emitting layer 6 (e.g. the first light-emitting sub-layer 611a and the second light-emitting sub-layer 611b in the first light-emitting layer 6), the hole blocking layer (HBL) and the electron transport layer (ETL) in the sub-pixel F, and omits other film layers in the sub-pixel F.

In addition, FIG. 12 shows a vacuum energy level of electrons. The greater the difference between the lowest unoccupied molecular orbital (LUMO) energy level or the highest occupied molecular orbital (HOMO) energy level and the vacuum energy level of electrons, the lower the lowest unoccupied molecular orbital (LUMO) energy level or the highest occupied molecular orbital (HOMO) energy level.

The first light-emitting layer 61 includes the first light-emitting sub-layer 611a and the second light-emitting sub-layer 611b adjacent to the first light-emitting sub-layer 611a, the first light-emitting sub-layer 611a is closer to the first electrode 311 than the second light-emitting sub-layer 611b, and an absolute value of the highest occupied molecular orbital (HOMO) energy level of the first light-emitting sub-layer 611a of the first light-emitting layer 61 is less than or equal to an absolute value of the highest occupied molecular orbital (HOMO) energy level of the second light-emitting sub-layer 611b of the first light-emitting layer 61.

That is, the highest occupied molecular orbital (HOMO) energy level of the first light-emitting sub-layer 611a of the first light-emitting layer 61 is higher than or equal to the highest occupied molecular orbital (HOMO) energy level of the second light-emitting sub-layer 611b of the first light-emitting layer 61.

It will be noted that FIG. 12 only shows the case where the absolute value of the highest occupied molecular orbital (HOMO) energy level of the first light-emitting sub-layer 611a is less than the absolute value of the highest occupied molecular orbital (HOMO) energy level of the second light-emitting sub-layer 611b. However, the embodiments of the present disclosure include but are not limited to this, and the absolute value of the highest occupied molecular orbital (HOMO) energy level of the first light-emitting sub-layer 611a may also be equal to the absolute value of the highest occupied molecular orbital (HOMO) energy level of the second light-emitting sub-layer 611b.

It will be understood that holes can easily jump from a film layer with a lower highest occupied molecular orbital (HOMO) energy level to a film layer with a higher highest occupied molecular orbital (HOMO) energy level. Conversely, it is difficult for holes to jump from a film layer with a higher highest occupied molecular orbital (HOMO) energy level to a film layer with a lower highest occupied molecular orbital (HOMO) energy level. Since the highest occupied molecular orbital (HOMO) energy level of the first light-emitting sub-layer 611a of the first light-emitting layer 61 is higher than or equal to the highest occupied molecular orbital (HOMO) energy level of the second light-emitting sub-layer 611b of the first light-emitting layer 61, when the sub-pixel F is subjected to an external electric field, holes cannot easily jump from the first light-emitting sub-layer 611a to the second light-emitting sub-layer 611b, which may prevent the holes injected by the first electrode 311 from being excessively transmitted to the second light-emitting sub-layer 611b, which facilitates the recombination of holes and electrons in the first light-emitting sub-layer 611a. Therefore, the recombination region (i.e., the light-emitting region) M of the first light-emitting layer 61 may be mostly or entirely located in the first light-emitting sub-layer 611a, which reduces the recombination region (i.e., the light-emitting region) M of the first light-emitting layer 61. Thus, the recombination region (i.e., the light-emitting region) M of the first light-emitting layer 61 is small, which is convenient for electrons and holes as carriers to recombine in the recombination region (i.e., the light-emitting region) M in the first light-emitting layer 61, which is conducive to improving the recombination efficiency of electrons e and holes h in the first light-emitting layer 61, and in turn reducing the bias voltage required for the display panel 10 and improving the light-emitting efficiency and performance of the display panel 10.

In some embodiments, with continued reference to FIG. 12, an absolute value of the highest occupied molecular orbital (HOMO) energy level of the electron blocking layer (EBL) is greater than or equal to the absolute value of the highest occupied molecular orbital (HOMO) energy level of the first light-emitting sub-layer 611a.

That is, the highest occupied molecular orbital (HOMO) energy level of the electron blocking layer (EBL) is lower than or equal to the highest occupied molecular orbital (HOMO) energy level of the first light-emitting sub-layer 611a.

It will be noted that FIG. 12 only shows the case where the absolute value of the highest occupied molecular orbital (HOMO) energy level of the electron blocking layer (EBL) is greater than the absolute value of the highest occupied molecular orbital (HOMO) energy level of the first light-emitting sub-layer 611a. However, the embodiments of the present disclosure include but are not limited to this. The absolute value of the highest occupied molecular orbital (HOMO) energy level of the electron blocking layer (EBL) may also be equal to the absolute value of the highest occupied molecular orbital (HOMO) energy level of the first light-emitting sub-layer 611a.

Holes can easily jump from a film layer with a lower highest occupied molecular orbital (HOMO) energy level to a film layer with a higher highest occupied molecular orbital (HOMO) energy level. Conversely, it is difficult for holes to jump from a film layer with a higher highest occupied molecular orbital (HOMO) energy level to a film layer with a lower highest occupied molecular orbital (HOMO) energy level. Since the highest occupied molecular orbital (HOMO) energy level of the electron blocking layer (EBL) is lower than or equal to the highest occupied molecular orbital (HOMO) energy level of the first light-emitting sub-layer 611a, when the sub-pixel F is subjected to an external electric field, holes can easily jump from the electron blocking layer (EBL) to the first light-emitting sub-layer 611a, which facilitates the recombination of electrons and holes as carriers in the first light-emitting sub-layer 611a and is conducive to improving the recombination efficiency of electrons and holes in the first light-emitting sub-layer 611a.

In some embodiments, with continued reference to FIG. 12, an absolute value of the highest occupied molecular orbital (HOMO) energy level of the hole transport layer (HTL) is less than or equal to the absolute value of the highest occupied molecular orbital (HOMO) energy level of the electron blocking layer (EBL).

That is to say, the highest occupied molecular orbital (HOMO) energy level of the hole transport layer (HTL) is higher than or equal to the highest occupied molecular orbital (HOMO) energy level of the electron blocking layer (EBL).

It will be noted that FIG. 12 only shows the case where the absolute value of the highest occupied molecular orbital (HOMO) energy level of the hole transport layer (HTL) is less than or equal to the absolute value of the highest occupied molecular orbital (HOMO) energy level of the electron blocking layer (EBL). However, the embodiments of the present disclosure include but are not limited to this, and the absolute value of the highest occupied molecular orbital (HOMO) energy level of the hole transport layer (HTL) may also be equal to the absolute value of the highest occupied molecular orbital (HOMO) energy level of the electron blocking layer (EBL).

Holes can easily jump from a film layer with a lower highest occupied molecular orbital (HOMO) energy level to a film layer with a higher highest occupied molecular orbital (HOMO) energy level. Conversely, it is difficult for holes to jump from a film layer with a higher highest occupied molecular orbital (HOMO) energy level to a film layer with a lower highest occupied molecular orbital (HOMO) energy level. Since the highest occupied molecular orbital (HOMO) energy level of the hole transport layer (HTL) is higher than or equal to the highest occupied molecular orbital (HOMO) energy level of the electron blocking layer (EBL), when the sub-pixel F is subjected to an external electric field, holes cannot easily jump from the hole transport layer (HTL) to the electron blocking layer (EBL). Therefore, holes may be accumulated at an interface between the hole transport layer (HTL) and the electron blocking layer (EBL), which avoids that holes in the hole transport layer (HTL) quickly pass through the electron blocking layer (EBL) to enter the first light-emitting layer 61. Thus, electrons and holes as carriers may be recombined at an interface of the first light-emitting layer 61 close to the electron blocking layer (EBL) (i.e. an interface of the first light-emitting sub-layer 611a close to the electron blocking layer (EBL)), and the recombination region (i.e., the light-emitting region) M of the first light-emitting layer 61 is entirely or nearly entirely located in the first light-emitting sub-layer 611a, which reduces the recombination region (i.e., the light-emitting region) M of the first light-emitting layer 61. As a result, the recombination region (i.e., the light-emitting region) M of the first light-emitting layer 61 is small, which is convenient for electrons and holes as carriers to recombine in the recombination region (i.e., the light-emitting region) M in the first light-emitting layer 61, which is conducive to further improving the recombination efficiency of electrons and holes in the first light-emitting layer 61, and in turn further reducing the bias voltage required for the display panel 10 and improving the light-emitting efficiency and performance of the display panel 10.

In some embodiments, with continued reference to FIG. 12, an absolute value of the lowest unoccupied molecular orbital (LUMO) energy level of the first light-emitting sub-layer 611a of the first light-emitting layer 61 is less than or equal to an absolute value of the lowest unoccupied molecular orbital (LUMO) energy level of the second light-emitting sub-layer 611b of the first light-emitting layer 61.

That is to say, the lowest unoccupied molecular orbital (LUMO) energy level of the first light-emitting sub-layer 611a of the first light-emitting layer 61 is higher than or equal to the lowest unoccupied molecular orbital (LUMO) energy level of the second light-emitting sub-layer 611b of the first light-emitting layer 61.

It will be noted that FIG. 12 only shows the case where the absolute value of the lowest unoccupied molecular orbital (LUMO) energy level of the first light-emitting sub-layer 611a is less than or equal to the absolute value of the lowest unoccupied molecular orbital (LUMO) energy level of the second light-emitting sub-layer 611b. However, the embodiments of the present disclosure include but are not limited to this. The absolute value of the lowest unoccupied molecular orbital (LUMO) energy level of the first light-emitting sub-layer 611a may also be equal to the absolute value of the lowest unoccupied molecular orbital (LUMO) energy level of the second light-emitting sub-layer 611b.

It will be understood that, according to the Aufbau principle (that is, under the condition of not violating the Pauli principle and Hund's rule, electrons preferentially occupy atomic orbitals with lower energy, so that the energy of the entire atomic system is at the lowest), electrons can easily jump from a film layer with a higher lowest unoccupied molecular orbital (LUMO) energy level to a film layer with a lower lowest unoccupied molecular orbital (LUMO) energy level. Conversely, it is difficult for electrons to jump from a film layer with a lower lowest unoccupied molecular orbital (LUMO) energy level to a film layer with a higher lowest unoccupied molecular orbital (LUMO) energy level. Since the lowest unoccupied molecular orbital (LUMO) energy level of the first light-emitting sub-layer 611a of the first light-emitting layer 61 is higher than or equal to the lowest unoccupied molecular orbital (LUMO) energy level of the second light-emitting sub-layer 611b of the first light-emitting layer 61, when the sub-pixel F is subjected to an external electric field, electrons cannot easily jump from the second light-emitting sub-layer 611b to the first light-emitting sub-layer 611a, which may avoid that electrons are transmitted from the second light-emitting sub-layer 611b to the first light-emitting sub-layer 611a too quickly, which is conducive to protecting the electron blocking layer (EBL) located on the side of the first light-emitting sub-layer 611a away from the second light-emitting sub-layer 611b, avoiding the failure of the electron blocking layer (EBL), and in turn improving the service life of the display panel 10.

In some embodiments, with continued reference to FIG. 12, an absolute value of the lowest unoccupied molecular orbital (LUMO) energy level of the hole blocking layer (HBL) is greater than or equal to an absolute value of the lowest unoccupied molecular orbital (LUMO) energy level of the second light-emitting sub-layer 611b.

That is to say, the lowest unoccupied molecular orbital (LUMO) energy level of the hole blocking layer (HBL) is lower than or equal to the lowest unoccupied molecular orbital (LUMO) energy level of the second light-emitting sub-layer 611b.

It will be noted that FIG. 12 only shows the case where the absolute value of the lowest unoccupied molecular orbital (LUMO) energy level of the hole blocking layer (HBL) is greater than the absolute value of the lowest unoccupied molecular orbital (LUMO) energy level of the second light-emitting sub-layer 611b. However, the embodiments of the present disclosure include but are not limited to this. The absolute value of the lowest unoccupied molecular orbital (LUMO) energy level of the hole blocking layer (HBL) may also be equal to the absolute value of the lowest unoccupied molecular orbital (LUMO) energy level of the second light-emitting sub-layer 611b.

Electrons can easily jump from a film layer with a higher lowest unoccupied molecular orbital (LUMO) energy level to a film layer with a lower lowest unoccupied molecular orbital (LUMO) energy level. Conversely, it is difficult for electrons to jump from a film layer with a lower lowest unoccupied molecular orbital (LUMO) energy level to a film layer with a higher lowest unoccupied molecular orbital (LUMO) energy level. Since the lowest unoccupied molecular orbital (LUMO) energy level of the hole blocking layer (HBL) is lower than or equal to the lowest unoccupied molecular orbital (LUMO) energy level of the second light-emitting sub-layer 611b, when the sub-pixel F is subjected to an external electric field, electrons cannot easily jump from the hole blocking layer (HBL) to the second light-emitting sub-layer 611b, which may avoid that electrons jump from the hole blocking layer (HBL) to the second light-emitting sub-layer 611b too quickly, and in turn avoid that electrons jump from the second light-emitting sub-layer 611b to the first light-emitting sub-layer 611a too quickly. Therefore, it is conducive to protecting the electron blocking layer (EBL) located on the side of the first light-emitting sub-layer 611a away from the second light-emitting sub-layer 611b, avoiding the failure of the electron blocking layer (EBL), and improving the service life of the display panel 10.

For example, with continued reference to FIG. 12, a difference n1 between the absolute value of the lowest unoccupied molecular orbital (LUMO) energy level of the hole blocking layer (HBL) and the absolute value of the lowest unoccupied molecular orbital (LUMO) energy level of the second light-emitting sub-layer 611b is less than or equal to 0.2 eV.

For example, the difference n1 between the absolute value of the lowest unoccupied molecular orbital (LUMO) energy level of the hole blocking layer (HBL) and the absolute value of the lowest unoccupied molecular orbital (LUMO) energy level of the second light-emitting sub-layer 611b may be 0, 0.03 eV, 0.05 eV, 0.08 eV, 0.1 eV, 0.12 eV, 0.15 eV, 0.18 eV or 0.2 eV.

Since the difference n1 between the absolute value of the lowest unoccupied molecular orbital (LUMO) energy level of the hole blocking layer (HBL) and the absolute value of the lowest unoccupied molecular orbital (LUMO) energy level of the second light-emitting sub-layer 611b is less than or equal to 0.2, that is, the difference n1 between the absolute value of the lowest unoccupied molecular orbital (LUMO) energy level of the hole blocking layer (HBL) and the absolute value of the lowest unoccupied molecular orbital (LUMO) energy level of the second light-emitting sub-layer 611b is small, the difficulty of electrons jumping from the hole blocking layer (HBL) to the second light-emitting sub-layer 611b is low. Therefore, it may be possible to avoid that electrons jump from the hole blocking layer (HBL) to the second light-emitting sub-layer 611b too quickly, avoid that electrons jump from the second light-emitting sub-layer 611b to the first light-emitting sub-layer 611a too quickly, protect the electron blocking layer (EBL) located on the side of the first light-emitting sub-layer 611a away from the second light-emitting sub-layer 611b, and avoid the failure of the electron blocking layer (EBL). In addition, it may ensure that electrons are transmitted from the second light-emitting sub-layer 611b to the first light-emitting sub-layer 611a, and facilitate the recombination of holes and electrons in the first light-emitting sub-layer 611a. Thus, the recombination region (i.e., the light-emitting region) M of the first light-emitting layer 61 may be mostly or entirely located in the first light-emitting sub-layer 611a, which is conducive to improving the recombination efficiency of electrons and holes in the first light-emitting layer 61, and in turn reducing the bias voltage required for the display panel 10 and improving the light-emitting efficiency and performance of the display panel 10.

In some embodiments, with continued reference to FIG. 12, an absolute value of the lowest unoccupied molecular orbital (LUMO) energy level of the electron transport layer (ETL) is greater than or equal to the absolute value of the lowest unoccupied molecular orbital (LUMO) energy level of the hole blocking layer (HBL).

That is to say, the lowest unoccupied molecular orbital (LUMO) energy level of the electron transport layer (ETL) is lower than or equal to the lowest unoccupied molecular orbital (LUMO) energy level of the hole blocking layer (HBL).

It should be noted that FIG. 12 only shows the case where the absolute value of the lowest unoccupied molecular orbital (LUMO) energy level of the electron transport layer (ETL) is greater than the absolute value of the lowest unoccupied molecular orbital (LUMO) energy level of the hole blocking layer (HBL). However, the embodiments of the present disclosure include but are not limited to this, and the absolute value of the lowest unoccupied molecular orbital (LUMO) energy level of the electron transport layer (ETL) may also be equal to the absolute value of the lowest unoccupied molecular orbital (LUMO) energy level of the hole blocking layer (HBL).

Electrons can easily jump from a film layer with a higher lowest unoccupied molecular orbital (LUMO) energy level to a film layer with a lower lowest unoccupied molecular orbital (LUMO) energy level. Conversely, it is difficult for electrons to jump from a film layer with a lower lowest unoccupied molecular orbital (LUMO) energy level to a film layer with a higher lowest unoccupied molecular orbital (LUMO) energy level. Since the lowest unoccupied molecular orbital (LUMO) energy level of the electron transport layer (ETL) is lower than or equal to the lowest unoccupied molecular orbital (LUMO) energy level of the hole blocking layer (HBL), when the sub-pixel F is subjected to an external electric field, electrons cannot easily jump from the electron transport layer (ETL) to the hole blocking layer (HBL), which may avoid that electrons jump from the electron transport layer (ETL) to the hole blocking layer (HBL) too quickly, and in turn avoid that electrons jump from the hole blocking layer (HBL) through the second light-emitting sub-layer 611b to the first light-emitting sub-layer 611a too quickly. Thus, it is conducive to protecting the electron blocking layer (EBL) located on the side of the first light-emitting sub-layer 611a away from the second light-emitting sub-layer 611b, avoiding the failure of the electron blocking layer (EBL), and in turn increasing the service life of the display panel 10.

For example, with continued reference to FIG. 12, a difference n2 between the absolute value of the lowest unoccupied molecular orbital (LUMO) energy level of the electron transport layer (ETL) and the absolute value of the lowest unoccupied molecular orbital (LUMO) energy level of the hole blocking layer (HBL) is less than or equal to 0.2 eV.

For example, the difference n2 between the absolute value of the lowest unoccupied molecular orbital (LUMO) energy level of the electron transport layer (ETL) and the absolute value of the lowest unoccupied molecular orbital (LUMO) energy level of the hole blocking layer (HBL) may be 0, 0.03 eV, 0.05 eV, 0.08 eV, 0.1 eV, 0.12 eV, 0.15 eV, 0.18 eV or 0.2 eV.

Since the difference n2 between the absolute value of the lowest unoccupied molecular orbital (LUMO) energy level of the electron transport layer (ETL) and the absolute value of the lowest unoccupied molecular orbital (LUMO) energy level of the hole blocking layer (HBL) is less than or equal to 0.2, that is, the difference n2 between the absolute value of the lowest unoccupied molecular orbital (LUMO) energy level of the electron transport layer (ETL) and the absolute value of the lowest unoccupied molecular orbital (LUMO) energy level of the hole blocking layer (HBL) is small, the difficulty of electrons jumping from the electron transport layer (ETL) to the hole blocking layer (HBL) is low. Therefore, it may be possible to avoid that electrons jump from the electron transport layer (ETL) to the hole blocking layer (HBL) too quickly, avoid that electrons jump from the hole blocking layer (HBL) through the second light-emitting sub-layer 611b to the first light-emitting sub-layer 611a too quickly, protect the electron blocking layer (EBL) located on the side of the first light-emitting sub-layer 611a away from the second light-emitting sub-layer 611b, and avoid the failure of the electron blocking layer (EBL). In addition, it may ensure that electrons are transmitted to the first light-emitting sub-layer 611a by sequentially passing through the electron transport layer (ETL), the hole blocking layer (HBL) and the second light-emitting sub-layer 611b, and facilitate the recombination of holes and electrons in the first light-emitting sub-layer 611a. Thus, the recombination region (i.e., the light-emitting region) M of the first light-emitting layer 61 may be mostly or entirely located in the first light-emitting sub-layer 611a, which is conducive to improving the recombination efficiency of electrons and holes in the first light-emitting layer 61, and in turn reducing the bias voltage required for the display panel 10 and improving the light-emitting efficiency and performance of the display panel 10.

In some embodiments, as shown in FIGS. 13A, 13B, 13C, 14A, 14B, 14C and 15, FIGS. 13A, 13B, 13C, 14A, 14B, 14C and 15 are each a diagram showing a film layer structure of a sub-pixel F in a display panel 10 according to some embodiments. In the case where the plurality of sub-pixels F in the display panel 10 include first color sub-pixels F1, second color sub-pixels F2, and third color sub-pixels F3, and the first color sub-pixels F1 are red sub-pixels, the second color sub-pixel F2 are green sub-pixels, and the third color sub-pixels F3 are blue sub-pixels, the light-emitting layer 6 in the first color sub-pixel F1 (i.e., the red sub-pixel) is a red light-emitting layer 6a, the light-emitting layer 6 in the second color sub-pixel F2 (i.e., the green sub-pixel) is a green light-emitting layer 6b, and the light-emitting layer 6 in the third color sub-pixel F3 (i.e., the blue sub-pixel) is a blue light-emitting layer 6c.

At least one of the red light-emitting layer 6a in the first color sub-pixel F1 (i.e., the red sub-pixel), the green light-emitting layer 6b in the second color sub-pixel F2 (i.e., the green sub-pixel) and the blue light-emitting layer 6c in the third color sub-pixel F3 (i.e., the blue sub-pixel) is the first light-emitting layer 61. That is to say, at least one of the red light-emitting layer 6a in the first color sub-pixel F1 (i.e., the red sub-pixel), the green light-emitting layer 6b in the second color sub-pixel F2 (i.e., the green sub-pixel) and the blue light-emitting layer 6c in the third color sub-pixel F3 (i.e., the blue sub-pixel) adopts the above related designs of the electron mobility, hole mobility, thickness, highest occupied molecular orbital (HOMO) energy level, and lowest unoccupied molecular orbital (LUMO) energy level of the first light-emitting layer 61.

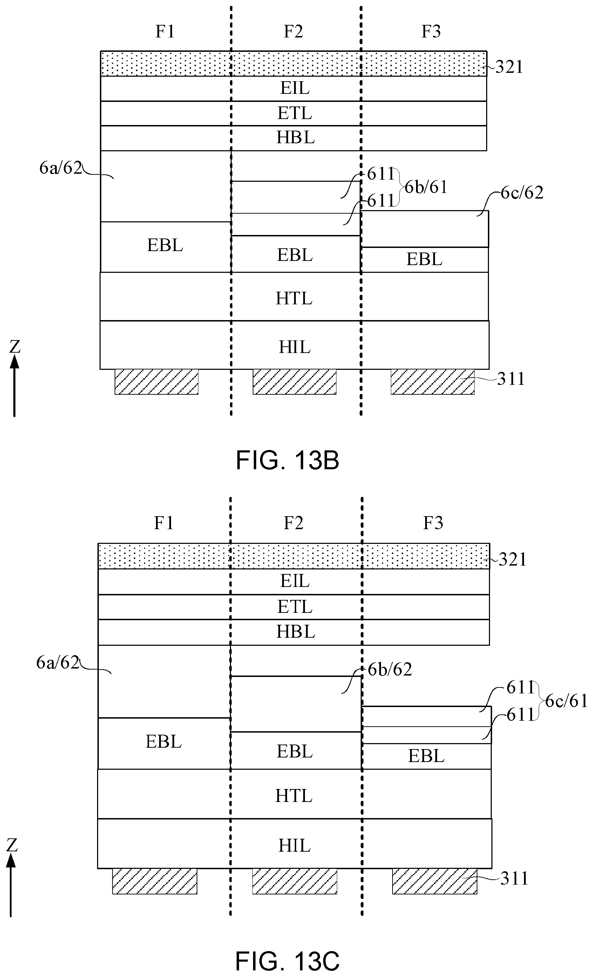

For example, with continued reference to FIGS. 13A, 13B and 13C, one of the red light-emitting layer 6a in the first color sub-pixel F1 (i.e., the red sub-pixel), the green light-emitting layer 6b in the second color sub-pixel F2 (i.e., the green sub-pixel) and the blue light-emitting layer 6c in the third color sub-pixel F3 (i.e., the blue sub-pixel) may be the first light-emitting layer 61.

For example, with continued reference to FIG. 13A, the red light-emitting layer 6a in the first color sub-pixel F1 (i.e., the red sub-pixel) may be the first light-emitting layer 61, the green light-emitting layer 6b in the second color sub-pixel F2 (i.e., the green sub-pixel) may be the second light-emitting layer 62, and the blue light-emitting layer 6c in the third color sub-pixel F3 (i.e., the blue sub-pixel) may be the second light-emitting layer 62.

Since the red light-emitting layer 6a in the first color sub-pixel F1 (i.e., the red sub-pixel) is the first light-emitting layer 61, the recombination region (i.e., the light-emitting region) of the red light-emitting layer 6a (i.e., the first light-emitting layer 61) may be reduced. Therefore, the recombination region (i.e., the light-emitting region) of the red light-emitting layer 6a (i.e., the first light-emitting layer 61) is small, which is convenient for electrons and holes as carriers to recombine in the recombination region (i.e., the light-emitting region) in the red light-emitting layer 6a (i.e., the first light-emitting layer 61), which is conducive to improving the recombination efficiency of electrons and holes in the red light-emitting layer 6a (i.e., the first light-emitting layer 61). As a result, the bias voltage required for the display panel 10 is reduced, and the light-emitting efficiency and performance of the display panel 10 are improved.

For another example, with continued reference to FIG. 13B, the green light-emitting layer 6b in the second color sub-pixel F2 (i.e., the green sub-pixel) may be the first light-emitting layer 61, the red light-emitting layer 6a in the first color sub-pixel F1 (i.e., the red sub-pixel) may be the second light-emitting layer 62, and the blue light-emitting layer 6c in the third color sub-pixel F3 (i.e., the blue sub-pixel) may be the second light-emitting layer 62.

Based on the same reason as in the embodiment shown in FIG. 13A where the red light-emitting layer 6a in the first color sub-pixel F1 (i.e., the red sub-pixel) is the first light-emitting layer 61, since the green light-emitting layer 6b in the second color sub-pixel F2 (i.e., the green sub-pixel) is the first light-emitting layer 61, the recombination efficiency of electrons and holes in the green light-emitting layer 6b (i.e., the first light-emitting layer 61) may be improved. As a result, the bias voltage required for the display panel 10 is reduced, and the light-emitting efficiency and performance of the display panel 10 are improved.

For another example, with continued reference to FIG. 13C, the blue light-emitting layer 6c in the third color sub-pixel F3 (i.e., the blue sub-pixel) may be the first light-emitting layer 61, the green light-emitting layer 6b in the second color sub-pixel F2 (i.e., the green sub-pixel) may be the second light-emitting layer 62, and the red light-emitting layer 6a in the first color sub-pixel F1 (i.e., the red sub-pixel) may be the second light-emitting layer 62.

Based on the same reason as in the embodiment shown in FIG. 13A where the red light-emitting layer 6a in the first color sub-pixel F1 (i.e., the red sub-pixel) is the first light-emitting layer 61, since the blue light-emitting layer 6c in the third color sub-pixel F3 (i.e., the blue sub-pixel) is the first light-emitting layer 61, the recombination efficiency of electrons and holes in the blue light-emitting layer 6c (i.e., the first light-emitting layer 61) may be improved. As a result, the bias voltage required for the display panel 10 is reduced, and the light-emitting efficiency and performance of the display panel 10 are improved.

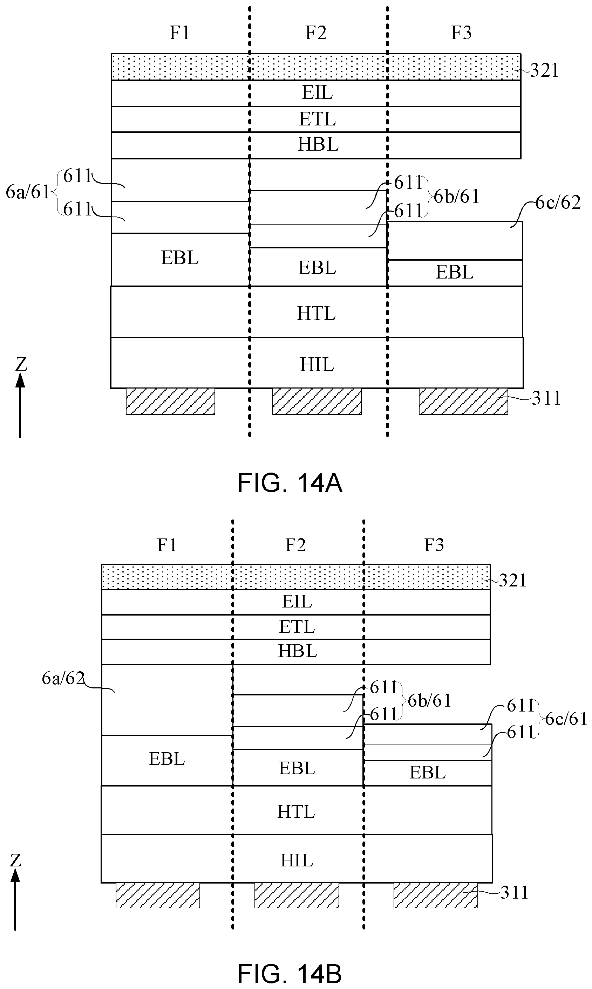

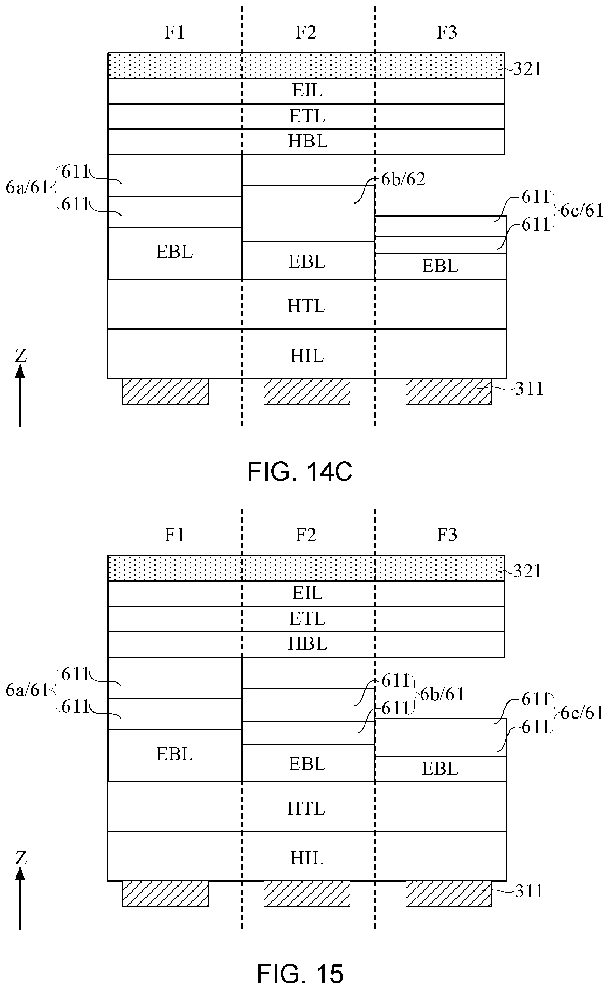

For example, with continued reference to FIGS. 14A, 14B and 14C, two of the red light-emitting layer 6a in the first color sub-pixel F1 (i.e., the red sub-pixel), the green light-emitting layer 6b in the second color sub-pixel F2 (i.e., the green sub-pixel) and the blue light-emitting layer 6c in the third color sub-pixel F3 (i.e., the blue sub-pixel) may be first light-emitting layers 61.

For example, with continued reference to FIG. 14A, the red light-emitting layer 6a in the first color sub-pixel F1 (i.e., the red sub-pixel) and the green light-emitting layer 6b in the second color sub-pixel F2 (i.e., the green sub-pixel) may both be the first light-emitting layers 61, and the blue light-emitting layer 6c in the third color sub-pixel F3 (i.e., the blue sub-pixel) may be the second light-emitting layer 62.

Since the red light-emitting layer 6a in the first color sub-pixel F1 (i.e., the red sub-pixel) and the green light-emitting layer 6b in the second color sub-pixel F2 (i.e., the green sub-pixel) may both be the first light-emitting layers 61, recombination regions (i.e., light-emitting regions) of the red light-emitting layer 6a (i.e., the first light-emitting layer 61) and the green light-emitting layer 6b (i.e., the first light-emitting layer 61) may be reduced. Therefore, the recombination regions (i.e., the light-emitting regions) of the red light-emitting layer 6a (i.e., the first light-emitting layer 61) and the green light-emitting layer 6b (i.e., the first light-emitting layer 61) are small, which facilitates the recombination of electrons and holes as carriers in the recombination regions (i.e., the light-emitting regions) in the red light-emitting layer 6a (i.e., the first light-emitting layer 61) and the green light-emitting layer 6b (i.e., the first light-emitting layer 61), which is conducive to improving the recombination efficiency of electrons and holes in the red light-emitting layer 6a (i.e., the first light-emitting layer 61) and the green light-emitting layer 6b (i.e., the first light-emitting layer 61). As a result, the bias voltage required for the display panel 10 is further reduced, and the light-emitting efficiency and performance of the display panel 10 are further improved.

For another example, with continued reference to FIG. 14B, the blue light-emitting layer 6c in the third color sub-pixel F3 (i.e., the blue sub-pixel) and the green light-emitting layer 6b in the second color sub-pixel F2 (i.e., the green sub-pixel) may be the first light-emitting layers 61, and the red light-emitting layer 6a in the first color sub-pixel F1 (i.e., the red sub-pixel) may be the second light-emitting layer 62.

Based on the same reason as in the embodiment shown in FIG. 14A where the red light-emitting layer 6a in the first color sub-pixel F1 (i.e., the red sub-pixel) and the green light-emitting layer 6b in the second color sub-pixel F2 (i.e., the green sub-pixel) are both the first light-emitting layers 61, since the blue light-emitting layer 6c in the third color sub-pixel F3 (i.e., the blue sub-pixel) and the green light-emitting layer 6b in the second color sub-pixel F2 (i.e., the green sub-pixel) are both the first light-emitting layers 61, the recombination efficiency of electrons and holes in the blue light-emitting layer 6c (i.e., the first light-emitting layer 61) and the green light-emitting layer 6b (i.e., the first light-emitting layer 61) may be improved. As a result, the bias voltage required for the display panel 10 is further reduced, and the light-emitting efficiency and performance of the display panel 10 are further improved.

For another example, with continued reference to FIG. 14C, the red light-emitting layer 6 in the first color sub-pixel F1 (i.e., the red sub-pixel) and the blue light-emitting layer 6c in the third color sub-pixel F3 (i.e., the blue sub-pixel) may be the first light-emitting layers 61, and the green light-emitting layer 6b in the second color sub-pixel F2 (i.e., the green sub-pixel) may be the second light-emitting layer 62.

Based on the same reason as in the embodiment shown in FIG. 14A where the red light-emitting layer 6a in the first color sub-pixel F1 (i.e., the red sub-pixel) and the green light-emitting layer 6b in the second color sub-pixel F2 (i.e., the green sub-pixel) are both the first light-emitting layers 61, since the red light-emitting layer 6a in the first color sub-pixel F1 (i.e., the red sub-pixel) and the blue light-emitting layer 6c in the third color sub-pixel F3 (i.e., the blue sub-pixel) are both the first light-emitting layers 61, the recombination efficiency of electrons and holes in the red light-emitting layer 6a (i.e., the first light-emitting layer 61) and the blue light-emitting layer 6c (i.e., the first light-emitting layer 61) may be improved. As a result, the bias voltage required for the display panel 10 is further reduced, and the light-emitting efficiency and performance of the display panel 10 are further improved.

For example, with continued reference to FIG. 15, the red light-emitting layer 6a in the first color sub-pixel F1 (i.e., the red sub-pixel), the green light-emitting layer 6b in the second color sub-pixel F2 (i.e., green sub-pixel), and the blue light-emitting layer 6c in the third color sub-pixel F3 (i.e., blue sub-pixel) may all be the first light-emitting layers 61.

Since the red light-emitting layer 6a in the first color sub-pixel F1 (i.e., the red sub-pixel), the green light-emitting layer 6b in the second color sub-pixel F2 (i.e., green sub-pixel), and the blue light-emitting layer 6c in the third color sub-pixel F3 (i.e., blue sub-pixel) are all first light-emitting layers 61, recombination regions (i.e., light-emitting regions) of the red light-emitting layer 6a (i.e., the first light-emitting layer 61), the green light-emitting layer 6b (i.e., the first light-emitting layer 61), and the blue light-emitting layer 6c (i.e., the first light-emitting layer 61) may all be reduced. Therefore, the recombination regions (i.e., the light-emitting regions) of the red light-emitting layer 6a (i.e., the first light-emitting layer 61), the green light-emitting layer 6b (i.e., the first light-emitting layer 61), and the blue light-emitting layer 6c (i.e., the first light-emitting layer 61) are all small, which facilitates the recombination of electrons and holes as carriers in the recombination regions (i.e., the light-emitting regions) in the red light-emitting layer 6a (i.e., the first light-emitting layer 61), the green light-emitting layer 6b (i.e., the first light-emitting layer 61), and the blue light-emitting layer 6c (i.e., the first light-emitting layer 61), which is conducive to improving the recombination efficiency of electrons and holes in the red light-emitting layer 6a (i.e., the first light-emitting layer 61), the green light-emitting layer 6b (i.e., the first light-emitting layer 61), and the blue light-emitting layer 6c (i.e., the first light-emitting layer 61). As a result, the bias voltage required for the display panel 10 is further reduced, and the light-emitting efficiency and performance of the display panel 10 are further improved.

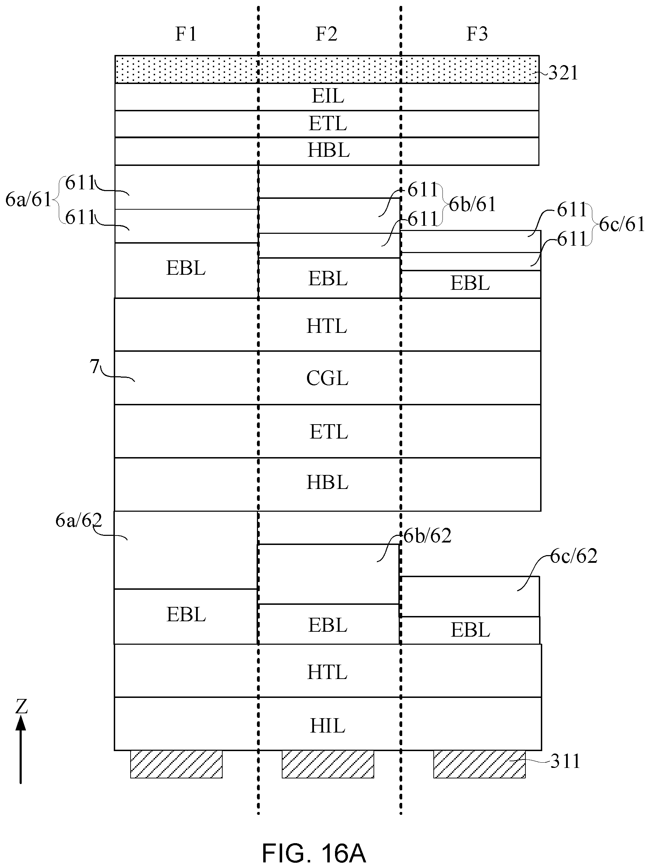

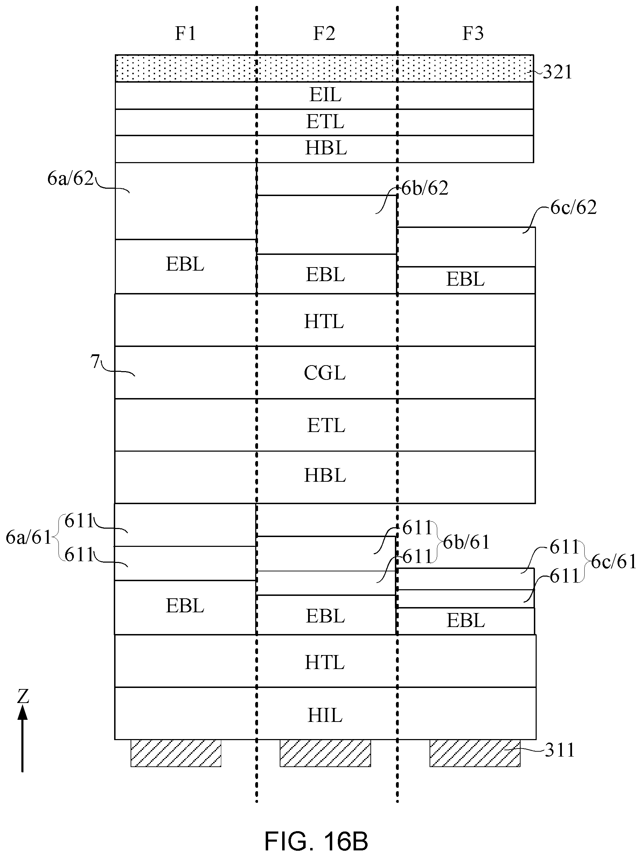

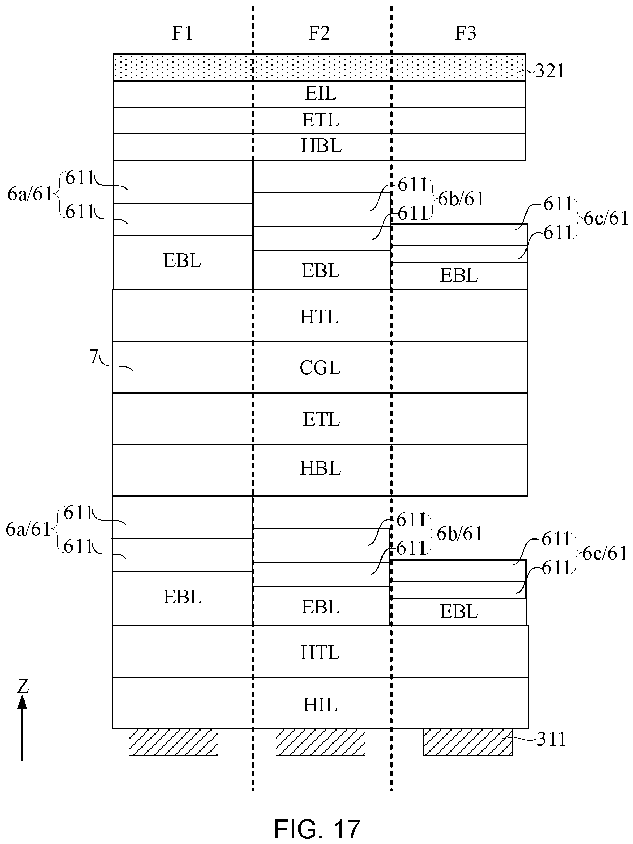

In some embodiments, as shown in FIGS. 16A, 16B, and 17, FIGS. 16A, 16B and 17 are each a diagram showing a film layer structure of a sub-pixel F in a display panel 10 according to some embodiments. The sub-pixel F in the display panel 10 includes at least two light-emitting layers 6 that are stacked and at least one charge generation layer (CGL) 7. A charge generation layer (CGL) 7 is disposed between any two adjacent light-emitting layers 6. The charge generation layer (CGL) 7 may connect the two adjacent light-emitting layers 6 in series, thereby realizing a tandem **EL** design.

Since the number of light-emitting layers 6 increases and the charge generation layer (CGL) 7 may reduce the driving voltage and generate new carriers, the light-emitting efficiency of the light-emitting layers 6 can be multiplied. In addition, at the same luminance, compared with a display panel 10 with a single-layer EL design, the display panel 10 with the tandem EL design has a lower current density, which is conducive to extending the service life of the display panel 10.

It will be noted that, in FIGS. 16A, 16B and 17, some embodiments of the present disclosure are schematically described by taking an example in which only the sub-pixel F in the display panel 10 includes two light-emitting layers 6 and one charge generation layer (CGL) 7 that are stacked. However, the embodiments of the present disclosure include but are not limited to this, and the number of the light-emitting layers 6 and the charge generation layer (CGL) 7 in the sub-pixel F in the display panel 10 may be set according to actual needs.

For example, the charge generation layer (CGL) 7 may be configured to generate carriers, transport carriers, and inject carriers.

For example, the charge generation layer (CGL) 7 may include an N-type charge generation layer (n-CGL) and a P-type charge generation layer (p-CGL).

The N-type charge generation layer (n-CGL) may include, for example, an organic electron transport layer (ETL) material doped with a metal material.

The P-type charge generation layer (p-CGL) may include, for example, an organic hole transport layer (HTL) material doped with a p-type light-emitting dopant (p-dopant or PD).

In some embodiments, with continued reference to FIGS. 16A and 16B, among the two light-emitting layers 6 located on two opposite sides of the charge generation layer (CGL) 7 in the sub-pixel F, one is the first light-emitting layer 61, and the other is the second light-emitting layer 62. That is, the charge generation layer (CGL) 7 is located between the first light-emitting layer 61 and the second light-emitting layer 62.

Since the sub-pixel F includes two light-emitting layers 6 and one of the two light-emitting layers 6 is the first light-emitting layer 61, the light-emitting efficiency of the light-emitting layers 6 is multiplied and the current density of the display panel 10 is reduced; moreover, the bias voltage required for the display panel 10 is reduced, and the light-emitting efficiency and performance of the display panel 10 are improved.

Specifically, considering the first color sub-pixel F1 (i.e., the red sub-pixel) as an example, with continued reference to FIGS. 16A and 16B, light-emitting layers 6 in the first color sub-pixel F1 (i.e., the red sub-pixel) are red light-emitting layers 6a. The first color sub-pixel F1 (i.e., the red sub-pixel) includes two red light-emitting layers 6a and a charge generation layer (CGL) 7 located between the two red light-emitting layers 6a. Since the number of red light-emitting layers 6a in the first color sub-pixel F1 (i.e., the red sub-pixel) is two, compared with the first color sub-pixel F1 (i.e., the red sub-pixel) in which there is one red light-emitting layer 6a, the number of red light-emitting layers 6a is multiplied. In addition, the charge generation layer (CGL) 7 may reduce the driving voltage and generate new carriers. Thus, the luminous efficiency of the red light-emitting layers 6a can be multiplied. Moreover, at the same luminance, compared with a display panel 10 with a single-layer EL design, the display panel 10 with the tandem EL design has a lower current density, which is conducive to extending the service life of the display panel 10.

Furthermore, the two red light-emitting layers 6a in the first color sub-pixel F1 (i.e., the red sub-pixel) include one first light-emitting layer 61 and one second light-emitting layer 62. Since the two red light-emitting layers 6a in the first color sub-pixel F1 (i.e., the red sub-pixel) include one first light-emitting layer 61, the recombination region (i.e., the light-emitting region) of the red light-emitting layer 6a (i.e., the first light-emitting layer 61) may be reduced. Therefore, the recombination region (i.e., the light-emitting region) of the red light-emitting layer 6a (i.e., the first light-emitting layer 61) is small, which is convenient for electrons and holes as carriers to recombine in the recombination region (i.e., the light-emitting region) in the red light-emitting layer 6a (i.e., the first light-emitting layer 61), which is conducive to improving the recombination efficiency of electrons and holes in the red light-emitting layer 6a (i.e., the first light-emitting layer 61). As a result, the bias voltage required for the display panel 10 is reduced, and the light-emitting efficiency and performance of the display panel 10 are improved.

Similarly, with continued reference to FIGS. 16A and 16B, when the sub-pixel F is the second color sub-pixel F2 (i.e., the green sub-pixel), light-emitting layers 6 in the second color sub-pixel F2 (i.e., the green sub-pixel) are green light-emitting layers 6b. Two green light-emitting layers 6b in the second color sub-pixel F2 (i.e., the green sub-pixel) include one first light-emitting layer 61 and one second light-emitting layer 62. Since the two green light-emitting layers 6b in the second color sub-pixel F2 (i.e., the green sub-pixel) include one first light-emitting layer 61, the recombination region (i.e., the light-emitting region) of the green light-emitting layer 6b (i.e., the first light-emitting layer 61) may be reduced. Therefore, the recombination region (i.e., the light-emitting region) of the green light-emitting layer 6b (i.e., the first light-emitting layer 61) is small, which is convenient for electrons and holes as carriers to recombine in the recombination region (i.e., the light-emitting region) in the green light-emitting layer 6b (i.e., the first light-emitting layer 61), which is conducive to improving the recombination efficiency of electrons and holes in the green light-emitting layer 6b (i.e., the first light-emitting layer 61). As a result, the bias voltage required for the display panel 10 is reduced, and the light-emitting efficiency and performance of the display panel 10 are improved.

When the sub-pixel F is the third color sub-pixel F3 (i.e., the blue sub-pixel), light-emitting layers 6 in the third color sub-pixel F3 (i.e., the blue sub-pixel) are blue light-emitting layers 6c. Two blue light-emitting layers 6c in the third color sub-pixel F3 (i.e., the blue sub-pixel) include one first light-emitting layer 61 and one second light-emitting layer 62. Since the two blue light-emitting layers 6c in the third color sub-pixel F3 (i.e., the blue sub-pixel) include one first light-emitting layer 61, the recombination region (i.e., the light-emitting region) of the blue light-emitting layer 6c (i.e., the first light-emitting layer 61) may be reduced. Therefore, the recombination region (i.e., the light-emitting region) of the blue light-emitting layer 6c (i.e., the first light-emitting layer 61) is small, which is convenient for electrons and holes as carriers to recombine in the recombination region (i.e., the light-emitting region) in the blue light-emitting layer 6c (i.e., the first light-emitting layer 61), which is conducive to improving the recombination efficiency of electrons and holes in the blue light-emitting layer 6c (i.e., the first light-emitting layer 61). As a result, the bias voltage required for the display panel 10 is reduced, and the light-emitting efficiency and performance of the display panel 10 are improved.

It will be noted that, in the case where the plurality of sub-pixels F in the display panel 10 include first color sub-pixels F1, second color sub-pixels F2, and third color sub-pixels F3, FIGS. 16A and 16B only illustrate examples in which the first color sub-pixel F1, the second color sub-pixel F2 and the third color sub-pixel F3 each include one first light-emitting layer 61. However, the embodiments of the present disclosure include but are not limited to this. For example, two of the first color sub-pixel F1, the second color sub-pixel F2, and the third color sub-pixel F3 may each include one first light-emitting layer 61, and the remaining one does not include the first light-emitting layer 61. For another example, one of the first color sub-pixel F1, the second color sub-pixel F2, and the third color sub-pixel F3 may include one first light-emitting layer 61, and the remaining two do not include the first light-emitting layer 61.

For example, with continued reference to FIG. 16A, the second light-emitting layer 62 may be closer to the first electrode 311 than the first light-emitting layer 61.

Alternatively, with continued reference to FIG. 16B, the second light-emitting layer 62 may be farther away from the first electrode 311 than the first light-emitting layer 61.

In some embodiments, with continued reference to FIG. 17, the sub-pixel F in the display panel 10 includes at least two first light-emitting layers 61 that are stacked, and a charge generation layer (CGL) 7 is disposed between any two adjacent first light-emitting layers 61. That is, the light-emitting layers 6 in the sub-pixels F in the display panel 10 are all first light-emitting layers 61.

Since the sub-pixel F includes at least two light-emitting layers 6 and the at least the two light-emitting layers are first light-emitting layers 61, the light-emitting efficiency of the light-emitting layers 6 is multiplied and the current density of the display panel 10 is reduced; moreover, the bias voltage required for the display panel 10 is further reduced, and the light-emitting efficiency and performance of the display panel 10 are further improved.

Specifically, considering the first color sub-pixel F1 (i.e., the red sub-pixel) as an example, with continued reference to FIG. 17, light-emitting layers 6 in the first color sub-pixel F1 (i.e., the red sub-pixel) are red light-emitting layers 6a. The first color sub-pixel F1 (i.e., the red sub-pixel) includes at least two red light-emitting layers 6a and a charge generation layer (CGL) 7 located between any two adjacent red light-emitting layers 6a. Since there are at least two red light-emitting layers 6a in the first color sub-pixel F1 (i.e., the red sub-pixel), compared with the first color sub-pixel F1 (i.e., the red sub-pixel) in which there is one red light-emitting layer 6a, the number of red light-emitting layers 6a is multiplied. In addition, the charge generation layer (CGL) 7 may reduce the driving voltage and generate new carriers. Thus, the luminous efficiency of the red light-emitting layers 6a can be multiplied. Moreover, at the same luminance, compared with a display panel 10 with a single-layer EL design, the display panel 10 with the tandem EL design has a lower current density, which is conducive to extending the service life of the display panel 10.

Furthermore, the at least two red light-emitting layers 6a in the first color sub-pixel F1 (i.e., the red sub-pixel) are all first light-emitting layers 61. Since the at least two red light-emitting layers 6a in the first color sub-pixel F1 (i.e., the red sub-pixel) are all first light-emitting layers 61, the recombination regions (i.e., the light-emitting regions) of the red light-emitting layers 6a (i.e., the first light-emitting layers 61) may be further reduced. Therefore, the recombination regions (i.e., the light-emitting regions) of the red light-emitting layers 6a (i.e., the first light-emitting layers 61) are small, which is convenient for electrons and holes as carriers to recombine in the recombination regions (i.e., the light-emitting regions) in the red light-emitting layers 6a (i.e., the first light-emitting layers 61), which is further conducive to improving the recombination efficiency of electrons and holes in the red light-emitting layers 6a (i.e., the first light-emitting layers 61). As a result, the bias voltage required for the display panel 10 is further reduced, and the light-emitting efficiency and performance of the display panel 10 are further improved.

Similarly, when the sub-pixel F is the second color sub-pixel F2 (i.e., the green sub-pixel) or the third color sub-pixel F3 (i.e., the blue sub-pixel), it may also be possible to further reduce the bias voltage required by the display panel 10 and further improve the light-emitting efficiency and performance of the display panel 10.

It will be noted that, in the case where the plurality of sub-pixels F in the display panel 10 include first color sub-pixels F1, second color sub-pixels F2, and third color sub-pixels F3, FIG. 17 only illustrates the example in which the light-emitting layers 6 in the first color sub-pixel F1, the second color sub-pixel F2, and the third color sub-pixel F3 are all first light-emitting layers 61. However, the embodiments of the present disclosure include but are not limited to this. For example, the light-emitting layers 6 in two of the first color sub-pixel F1, the second color sub-pixel F2 and the third color sub-pixel F3 may all be the first light-emitting layers 61, and the remaining one of the first color sub-pixel F1, the second color sub-pixel F2 and the third color sub-pixel F3 may include a second light-emitting layer 62. For another example, the light-emitting layers 6 in one of the first color sub-pixel F1, the second color sub-pixel F2 and the third color sub-pixel F3 may all be the first light-emitting layers 61, and the remaining two of the first color sub-pixel F1, the second color sub-pixel F2 and the third color sub-pixel F3 may include a second light-emitting layer 62.

The foregoing descriptions are merely specific implementations of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A display panel, comprising:
a first electrode, a first light-emitting layer, and a second electrode that are stacked in sequence, wherein the first electrode is configured to inject holes into the first light-emitting layer, and the second electrode is configured to inject electrons into the first light-emitting layer;
the first light-emitting layer includes at least two light-emitting sub-layers that are stacked;
hole mobility of each light-emitting sub-layer is less than electron mobility of the light-emitting sub-layer.

2. The display panel according to claim 1, wherein a ratio of the electron mobility to the hole mobility of each light-emitting sub-layer is greater than or equal to 10.

3. The display panel according to claim 1 or 2, wherein the first light-emitting layer includes a first light-emitting sub-layer and a second light-emitting sub-layer adjacent to the first light-emitting sub-layer; the first light-emitting sub-layer is closer to the first electrode than the second light-emitting sub-layer; and a thickness of the first light-emitting sub-layer is less than a thickness of the second light-emitting sub-layer.

4. The display panel according to any one of claims 1 to 3, wherein a thickness of a first light-emitting sub-layer is in a range of 5 nm to 10 nm.

5. The display panel according to any one of claims 1 to 4, wherein the first light-emitting layer includes a first light-emitting sub-layer and a second light-emitting sub-layer adjacent to the first light-emitting sub-layer; the first light-emitting sub-layer is closer to the first electrode than the second light-emitting sub-layer;
electron mobility of the second light-emitting sub-layer is greater than electron mobility of the first light-emitting sub-layer.

6. The display panel according to claim 5, wherein the first light-emitting layer includes at least three light-emitting sub-layers; and in a direction from the first electrode to the second electrode, electron mobility of the at least three light-emitting sub-layers increases sequentially.

7. The display panel according to any one of claims 1 to 6, wherein the first light-emitting layer includes a first light-emitting sub-layer and a second light-emitting sub-layer adjacent to the first light-emitting sub-layer; the first light-emitting sub-layer is closer to the first electrode than the second light-emitting sub-layer;
hole mobility of the second light-emitting sub-layer is greater than or equal to hole mobility of the first light-emitting sub-layer.

8. The display panel according to claim 7, wherein the first light-emitting layer includes at least three light-emitting sub-layers; and in a direction from the first electrode to the second electrode, hole mobility of the at least three light-emitting sub-layers increases sequentially.

9. The display panel according to any one of claims 1 to 8, wherein an absolute value of a highest occupied molecular orbital energy level of a first light-emitting sub-layer of the first light-emitting layer is less than or equal to an absolute value of a highest occupied molecular orbital energy level of a second light-emitting sub-layer of the first light-emitting layer;
an absolute value of a lowest unoccupied molecular orbital energy level of the first light-emitting sub-layer of the first light-emitting layer is less than or equal to an absolute value of a lowest unoccupied molecular orbital energy level of the second light-emitting sub-layer of the first light-emitting layer.

10. The display panel according to any one of claims 1 to 9, wherein the display panel further comprises a hole transport layer and an electron blocking layer that are stacked in sequence in a direction away from the first electrode, and the hole transport layer and the electron blocking layer are located between a first light-emitting sub-layer and the first electrode;
an absolute value of a highest occupied molecular orbital energy level of the hole transport layer is less than or equal to an absolute value of a highest occupied molecular orbital energy level of the electron blocking layer.

11. The display panel according to claim 10, wherein the absolute value of the highest occupied molecular orbital energy level of the electron blocking layer is greater than or equal to an absolute value of a highest occupied molecular orbital energy level of the first light-emitting sub-layer.

12. The display panel according to any one of claims 1 to 11, wherein the display panel further comprises a hole blocking layer located between a second light-emitting sub-layer and the second electrode;
an absolute value of a lowest unoccupied molecular orbital energy level of the hole blocking layer is greater than or equal to an absolute value of a lowest unoccupied molecular orbital energy level of the second light-emitting sub-layer.

13. The display panel according to claim 12, wherein a difference between the absolute value of the lowest unoccupied molecular orbital energy level of the hole blocking layer and the absolute value of the lowest unoccupied molecular orbital energy level of the second light-emitting sub-layer is less than or equal to 0.2 eV.

14. The display panel according to any one of claims 1 to 13, wherein the display panel further comprises an electron transport layer located between a hole blocking layer and the second electrode;
an absolute value of a lowest unoccupied molecular orbital energy level of the electron transport layer is greater than or equal to an absolute value of a lowest unoccupied molecular orbital energy level of the hole blocking layer.

15. The display panel of claim 14, wherein a difference between the absolute value of the lowest unoccupied molecular orbital energy level of the electron transport layer and the absolute value of the lowest unoccupied molecular orbital energy level of the hole blocking layer is less than or equal to 0.2 eV.

16. The display panel according to any one of claims 1 to 15, wherein the display panel comprises a red light-emitting layer, a green light-emitting layer, and a blue light-emitting layer;
at least one of the red light-emitting layer, the green light-emitting layer, and the blue light-emitting layer is the first light-emitting layer.

17. The display panel according to claim 16, wherein each of the red light-emitting layer, the green light-emitting layer, and the blue light-emitting layer is the first light-emitting layer.

18. The display panel according to any one of claims 1 to 17, wherein the display panel comprises at least two first light-emitting layers that are stacked;
the display panel further comprises at least one charge generation layer; and a charge generation layer is disposed between any two adjacent first light-emitting layers.

19. The display panel according to any one of claims 1 to 17, wherein the display panel further comprises a second light-emitting layer and a charge generation layer, the charge generation layer being located between the first light-emitting layer and the second light-emitting layer; wherein
the second light-emitting layer is of a single-layer structure;
the second light-emitting layer is closer to the first electrode than the first light-emitting layer, or the second light-emitting layer is farther away from the first electrode than the first light-emitting layer.

20. A display apparatus, comprising:
the display panel according to any one of claims 1 to 19; and
a cover plate disposed on a light exit side of the display panel.
